(19) Europäisches Patentamt
European Patent Office
Office européen des brevets

(11) **EP 4 509 881 A1**

(12) **EUROPEAN PATENT APPLICATION**
published in accordance with Art. 153(4) EPC

(43) Date of publication:
**19.02.2025 Bulletin 2025/08**

(21) Application number: **22937260.2**

(22) Date of filing: **06.12.2022**

(51) International Patent Classification (IPC):
*G01T 1/24* (2006.01)  *H01L 27/146* (2006.01)
*H01L 31/0224* (2006.01)

(86) International application number:
**PCT/CN2022/136856**

(87) International publication number:
**WO 2023/197628 (19.10.2023 Gazette 2023/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.04.2022 CN 202210372869**

(71) Applicant: Raycan Technology Co., Ltd. (Suzhou)
**Suzhou New District
Suzhou, Jiangsu 215163 (CN)**

(72) Inventors:
• **LIU, Yuqing**
  **Suzhou, Jiangsu 215163 (CN)**
• **XIE, Zizhuo**
  **Suzhou, Jiangsu 215163 (CN)**
• **QIU, Ao**
  **Suzhou, Jiangsu 215163 (CN)**
• **XIE, Qingguo**
  **Suzhou, Jiangsu 215163 (CN)**
• **XIAO, Peng**
  **Suzhou, Jiangsu 215163 (CN)**
• **HUA, Yuexuan**
  **Suzhou, Jiangsu 215163 (CN)**

(74) Representative: **Müller Verweyen
Patentanwälte
Friedensallee 290
22763 Hamburg (DE)**

(54) **SUB-PIXEL IMAGING METHOD AND APPARATUS, IMAGING DEVICE, DETECTOR, AND STORAGE MEDIUM**

(57)    In the present application disclosed are a sub-pixel imaging method and device, an imaging apparatus, a detector and a storage medium. The sub-pixel imaging method comprises: using a photon detector comprising a plurality of microcells to receive incident photons, such that pulse signals are generated by corresponding microcells receiving the incident photons, reading out the generated pulse signals, wherein there are different characteristics of the readout pulse signals when a given photon is incident on different microcells, based on characteristics of the readout pulse signals, determining corresponding microcells receiving the incident photons and/or determining incident photon intensity distribution of different microcells of the photon detector. Compared with existing photon detectors that use the entire photosensitive area as the minimum sensing unit, the sub-pixel imaging method, device, imaging apparatus, detector and storage medium of the embodiments of the present application have higher photon resolution without changing the physical size of existing photoelectric devices.

| Applying predetermined excitation to multiple microcells of the photon detector | S210 |

| Using a photon detector comprising multiple microcells to receive incident photons, such that pulse signals are generated by corresponding microcells receiving the incident photons | S220 |

| Reading out the generated pulse signals | S230 |

| Based on characteristics of the readout pulse signals, determining corresponding microcells receiving the incident photons and/or determining incident photon intensity of different microcells of the photon detector | S240 |

FIG. 2A

## Description

The application claims the priority of Chinese patent application No.202210372869.3 filed on April 11, 2022, the entirety of which is incorporated herein by reference.

## Technical Field

The present application relates to the field of photon detection, and in particular, to a sub-pixel imaging method and device, an imaging apparatus, a detector and a storage medium.

## Background

With the development of science and technology, weak light detection technology has been widely used in various fields, and photon counting devices such as photodiodes, single photon detection, photomultiplier tubes, and image sensors have developed rapidly. In addition to higher requirements for detection efficiency, sensitivity and other indicators, there are higher requirements in the medical imaging field such as for a PET for the imaging resolution and position detection accuracy of photon counters.

Silicon photomultiplier (SiPM) is a weak light detection image sensor composed of an avalanche photodiode array working in Geiger mode, which has the characteristics of high gain, high sensitivity, low bias voltage, magnetic field insensitivity, and compact structure. In recent years, it has developed rapidly and is widely considered to be the development direction of ultra-weak light detectors in the future. In some known technologies, each SiPM consists of a large number of microcells, each microcell consists of an avalanche photodiode (APD) and a quenching resistor in series, and each quenching resistor has the same resistance value. When incident photons are present, the corresponding microcells will generate electrical pulses, which are output after being superimposed through a readout circuit. Therefore, in specific imaging application scenarios, typically only the total number of photons received by the entire SiPM can be calculated, with the entire photosensitive area of a single SiPM as the minimum sensing unit (also called a pixel) for imaging, and more precise position information cannot be obtained.

In advanced imaging applications such as positron emission computed tomography (PET), night vision devices, and autonomous driving, the demand for imaging resolution continues to increase. Continuing to reduce the physical size of photoelectric multiplier devices will greatly increase the complexity of backend readout circuits, which will greatly increase costs. Therefore, it is needed to propose a solution that can achieve higher precision imaging performance based on the existing physical size of photoelectric devices.

The background description is provided merely to aid in understanding of the background of the present disclosure, and does not constitute an admission of prior art.

## Summary

Therefore, the present application intends to provide a sub-pixel imaging method and device, imaging apparatus, photon detector and related electronic device and storage medium, which can solve at least one problem existing in the prior art.

In a first aspect, a sub-pixel imaging method, preferably a sub-pixel imaging method for photon signal is provided, comprising: using a photon detector comprising a plurality of microcells to receive incident photons, such that pulse signals are generated by the corresponding microcells which receive the incident photons, reading out the generated pulse signals, wherein for different microcells on which a given photon is incident, there are different characteristics of the readout pulse signals, and based on the characteristics of the readout pulse signals, determining which corresponding microcells receiving the incident photons and/or determining the incident photon intensity distribution of the microcells of the photon detector.

In embodiments of the present invention, the microcells comprise a photon sensing module and a pulse signal generating module, wherein the photon sensing module receives the incident photons, and the pulse signal generating module generates the pulse signals. Specifically, the photon detector may comprise a silicon photomultiplier (SiPM), the photon sensing module comprises an avalanche photodiode, and the pulse signal generating module is selected from any of a quenching resistor, a quenching circuit and a transistor.

In embodiments of the present invention, where given photons are incident on different microcells, the characteristics of the pulse signals that may be read out are different.

In embodiments of the present invention, the incident photons being incident on different microcells may cover at least one of the following situations: a single photon being incident on the respective microcell or multiple photons being incident on the respective microcell.

In embodiments of the present invention, the different characteristics of the readout pulse signals may cover at least one of the following situations: the individual characteristics (such as pulse amplitude and/or pulse shape) of the pulse signals generated by different microcells are different, the inherent characteristics of the pulse signals generated by different microcells are the same but are read out in different manners such that the individual characteristics (such as pulse amplitude and/or pulse shape) and/or combined characteristics (such as number of pulses) of the readout pulse signals are different, the inherent characteristics of the pulse signals generated by different microcells are different and are read out in different manners such that the individual characteristics (such as pulse amplitude and/or pulse shape) and/or combined characteristics (such as number of pulses) of the readout electrical pulse signals are different.

Optionally, at least a portion of the microcells or each of the microcells have different response coefficients from each other.

Optionally, reading out the generated pulse signals comprises: using a single readout module to read out single-channel pulse signals from the plurality of the microcells which are arranged in parallel.

Optionally, reading out the generated pulse signals comprises: using a plurality of readout modules to read out multi-channel pulse signals from the plurality of microcells, with each of the plurality of the readout modules connected to the microcells in a different manner from each other.

Optionally, at least a portion of or each of the microcells are configured with a different pulse signal generating module from each other, such that at least a portion of or each of the microcells have different response coefficients from each other.

Optionally, each of the plurality of the microcells has a same response coefficient, and accordingly, reading out the generated pulse signals, comprises: using a plurality of readout modules to read out multi-channel pulse signals from the plurality of the microcells, wherein each of the plurality of the readout modules is connected to the microcells in a different manner from each other.

Optionally, the plurality of the microcells have a first portion of the microcells with different response coefficients from each other, and a second portion of the microcells having the same response coefficient, and accordingly, reading out the generated pulse signals, comprises: using a first readout module to read out single-channel pulse signals from the first portion of the microcells which are arranged in parallel, and using a plurality of second readout modules to read out multi-channel pulse signals from the second portion of the microcells, wherein each of the second readout modules is connected to the microcells in a different manner from each other.

Optionally, the plurality of the microcells have a first portion of the microcells with different response coefficients from each other, and a second portion of the microcells having the same response coefficient, and accordingly, reading out the generated pulse signals, comprises: using a plurality of first readout modules to read out multi-channel pulse signals from the first portion of the microcells, wherein each of the first readout modules is connected to the microcells in a different manner from each other, and using a plurality of second readout modules to read out multi-channel pulse signals from the second portion of the microcells, wherein each of the second readout modules is connected to the microcells in a different manner from each other.

Optionally, the plurality of the microcells form a microcell array comprising one or more first microcell rows or columns and one or more second microcell rows or columns, each first microcell row or column has different response coefficients from each other, each second microcell row or column has the same response coefficient, and accordingly, reading out the generated pulse signals, comprises: using a first readout module to read out single-channel pulse signals from each first microcell row or column, respectively, and using a plurality of second readout modules to read out multi-channel pulse signals from the respective second microcell rows or columns, respectively, wherein each of the second readout module connected to the same second microcell row or column is connected to the microcells in a different manner from each other.

Optionally, the plurality of the microcells form a microcell array comprising one or more first microcell rows or columns and one or more second microcell rows or columns, each first microcell row or column has different response coefficients from each other, each second microcell row or column has the same response coefficient, and accordingly, reading out the generated pulse signals, comprises: using a plurality of first readout modules to read out multi-channel pulse signals from the respective first microcell rows or columns, respectively, wherein each of the first readout modules connected to the same first microcell row or column is connected to the microcells in a different manner from each other, and using a plurality of second readout modules to read out multi-channel pulse signals from the respective second microcell rows or columns, respectively, wherein each of the second readout module connected to the same second microcell row or column is connected to the microcells in a different manner from each other.

Optionally, at least a portion of or each of the microcells is configured to have a photon sensing module and a pulse signal generating module of the same such that at least the portion or each of the microcells have the same response coefficient.

Optionally, based on the characteristics of the readout pulse signals, determining which corresponding microcells receiving the incident photons and/or determining the incident photon intensity distribution of the microcells of the photon detector, comprises: reconstructing the readout pulse signals to obtain an incident photon intensity distribution map of each microcell of the photon detector.

Optionally, reconstructing the readout pulse signals to obtain an incident photon intensity distribution map of each microcell of the photon detector, comprises: based on response coefficients of the plurality of microcells and/or connection manners of the plurality of microcells, constructing one or more pulse distribution coefficient matrices, and based on a predetermined reconstruction algorithm, using the one or more pulse distribution coefficient matrices and the readout pulse signals to reconstruct the incident photon intensity distribution map of the microcells.

Optionally, based on the characteristics of the readout pulse signals, determining which corresponding microcells receiving the incident photons, comprises: reconstructing the read pulse signals to obtain the positions of the microcells receiving the photons in the photon detector.

Optionally, reconstructing the read pulse signals to obtain the positions of the microcells receiving the photons in the photon detector, comprises: establishing a correspondence between characteristics of the pulse signals and the microcells with different response coefficients, and determining the positions of the corresponding microcells based on the correspondence and the different characteristics of the readout pulse signals.

Optionally, using a photon detector comprising a plurality of microcells to receive incident photons, comprises: using the photon detector to receive a single incident photon within a predetermined duration and/or a predetermined unit area, such that a single pulse signal is generated by the corresponding microcell receiving the single incident photon.

Optionally, based on the characteristics of the readout pulse signals, determining which corresponding microcells receiving the incident photons, comprises: directly determining the corresponding microcell receiving the single incident photon based on the single pulse signal read out within a predetermined period.

Optionally, the sub-pixel imaging method further comprises: applying a predetermined excitation to the plurality of the microcells of the photon detector. In particular, the predetermined excitation comprises a bias voltage.

Optionally, before receiving the incident photons, the sub-pixel imaging method further comprises: using a scintillator or a scintillator array coupled to the photon detector to receive incident high energy particles to generate the incident photons.

In a second aspect, a sub-pixel imaging device is provided, comprising: a photon detector comprising a plurality of microcells configured to receive incident photons, such that pulse signals are generated by the corresponding microcells which receive the incident photons, a readout module configured to read out the generated pulse signals, wherein for different microcells on which a given photon is incident, there are different characteristics of the readout pulse signals, and a reconstruction module configured to based on the characteristics of the readout pulse signals, determine which corresponding microcells receiving the incident photons and/or determine the incident photon intensity distribution of the microcells of the photon detector.

Optionally, the microcells comprise a photon sensing module and a pulse signal generating module, wherein the photon sensing module receives the incident photons, and the pulse signal generating module generates the pulse signals. Specifically, the photon detector may for example be a silicon photomultiplier, the photon sensing module is an avalanche photodiode, and the pulse signal generating module is selected from any of a quenching resistor, a quenching circuit and a transistor.

Optionally, at least a portion of the microcells or each of the microcells have different response coefficients from each other.

Optionally, the sub-pixel imaging device comprises a single readout module configured to read out single-channel pulse signals from the plurality of the microcells which are arranged in parallel.

Optionally, the sub-pixel imaging device comprises a plurality of readout modules with each readout module connected to the microcells in a different manner from each other, wherein the plurality of the readout modules are configured to read out multi-channel pulse signals from the plurality of microcells.

Optionally, at least a portion of or each of the microcells are configured with a different pulse signal generating module from each other, such that at least a portion of or each of the microcells have different response coefficients from each other.

Optionally, each of the plurality of the microcells has a same response coefficient, and the sub-pixel imaging device comprises a plurality of readout modules with each readout module connected to the microcells in a different manner from each other, and wherein the plurality of the readout modules are configured to read out multi-channel pulse signals from the plurality of microcells.

Optionally, the plurality of the microcells have a first portion of the microcells with different response coefficients from each other, and a second portion of the microcells having the same response coefficient, wherein the readout module comprises a first readout module and a plurality of second readout modules, wherein the first readout module is configured to read out single-channel pulse signals from the first portion of the microcells which are arranged in parallel, and the plurality of the second readout modules are configured to read out multi-channel pulse signals from the second portion of the microcells, wherein each of the second readout modules is connected to the microcells in a different manner from each other.

Optionally, the plurality of the microcells have a first portion of the microcells with different response coefficients from each other, and a second portion of the microcells having the same response coefficient, and the readout module comprises a plurality of first readout modules and a plurality of second readout modules, wherein the plurality of the first readout modules are configured to read out multi-channel pulse signals from the first portion of the microcells, wherein each of the first readout modules is connected to the microcells in a different manner from each other, and the plurality of the second readout modules are configured to read out multi-channel pulse signals from the second portion of the microcells, wherein each of the second readout modules is connected to the microcells in a different manner from each other.

Optionally, the plurality of the microcells form a microcell array comprising one or more first microcell rows or columns and one or more second microcell rows or columns, each first microcell row or column has different response coefficients from each other, each second microcell row or column has the same response coefficient, and wherein the readout module comprises a first readout module and a plurality of second readout modules, wherein the first readout module is configured to read out single-channel pulse signals from each first microcell row or column, respectively, and the plurality of the second readout modules are configured to read out multi-channel pulse signals from the respective second microcell rows or columns, respectively, wherein each of the second readout module connected to the same second microcell row or column is connected to the microcells in a different manner from each other.

Optionally, the plurality of the microcells form a microcell array comprising one or more first microcell rows or columns and one or more second microcell rows or columns, each first microcell row or column has different response coefficients from each other, each second microcell row or column has the same response coefficient, and accordingly, wherein the readout module comprises a plurality of first readout modules and a plurality of second readout modules, wherein the first readout module is configured to read out single-channel pulse signals from each first microcell row or column, respectively, and the plurality of the second readout modules are configured to read out multi-channel pulse signals from the respective second microcell rows or columns, respectively, wherein each of the second readout module connected to the same second microcell row or column is connected to the microcells in a different manner from each other.

Optionally, the plurality of the microcells form a microcell array comprising one or more first microcell rows or columns and one or more second microcell rows or columns, each first microcell row or column has different response coefficients from each other, each second microcell row or column has the same response coefficient, and accordingly, wherein the plurality of the first readout modules are configured to read out multi-channel pulse signals from the respective first microcell rows or columns, respectively, wherein each of the first readout modules connected to the same first microcell row or column is connected to the microcells in a different manner from each other, and the plurality of the second readout modules are configured to read out multi-channel pulse signals from the respective second microcell rows or columns, respectively, wherein each of the second readout module connected to the same second microcell row or column is connected to the microcells in a different manner from each other.

Optionally, at least a portion of or each of the microcells is configured to have the photon sensing module and the pulse signal generating module of the same such that at least the portion or each of the microcells have the same response coefficient.

Optionally, the reconstruction module is configured to use one or more pulse distribution coefficient matrices constructed based on the response coefficients of the plurality of microcells and/or the connection manners of the plurality of microcells, and a predetermined reconstruction algorithm to reconstruct an incident photon intensity distribution map of the microcells.

Optionally, the reconstruction module is configured to determine the positions of the corresponding microcells based on a pre-established correspondence between characteristics of the pulse signals and the microcells with different response coefficients, and the different characteristics of the readout pulse signals.

Optionally, the photon detector is configured to receive a single incident photon within a predetermined duration and/or a predetermined unit area, such that a single pulse signal is generated by the corresponding microcell receiving the single incident photon, wherein the readout module is configured to read out the single pulse signal generated within a predetermined period, and wherein the reconstruction module is configured to directly determine the corresponding microcell receiving the single incident photon based on the single pulse signal read out within the predetermined period.

Optionally, the sub-pixel imaging device further comprises: an excitation unit configured to apply a predetermined excitation to the plurality of the microcells of the photon detector. Specifically, the excitation unit comprises a voltage applying unit and the predetermined excitation may be a bias voltage.

Optionally, the sub-pixel imaging device further comprises: a scintillator or a scintillator array coupled to the photon detector, wherein the scintillator or the scintillator array is configured to generate the incident photons in response to incident high energy particles.

In a third aspect, a sub-pixel imaging apparatus is provided, comprising a sub-pixel imaging device according to any embodiment of the present application.

Optionally, the imaging apparatus is selected from one of the apparatuses utilizing the principle of high-energy radiation conversion, such as a PET apparatus, a CT apparatus, an MRI apparatus, a radiation detection apparatus, an oil detection apparatus, a low light detection apparatus, an SPECT apparatus, a security inspection apparatus, a gamma camera, an X-ray apparatus and a DR apparatus, or any combination thereof.

In a fourth aspect, a photon detector is provided, comprising a plurality of microcells, wherein the microcells comprise a photon sensing module and a pulse signal generating module, the photon sensing module is configured to receive an incident photon, the pulse signal generating module is configured to generate a pulse signal based on the received incident photon, wherein for different microcells on which a given photon is incident, there are different characteristics of the readout pulse signals.

Optionally, at least a portion of the plurality of the microcells have different response coefficients from each other.

Specifically, the photon detector may comprise a silicon photomultiplier, the photon sensing module comprises an avalanche photodiode, and the pulse signal generating module comprises a quenching resistor, a quenching circuit or a transistor.

Optionally, each of the plurality of the microcells has a different response coefficient from each other.

Optionally, the photon detector further comprises a single readout interface, wherein the plurality of the microcells are arranged to be in parallel connected to the single readout interface.

Optionally, the photon detector further comprises a plurality of readout interfaces, each readout interface is connected to at least one of the microcells, and each readout interface is configured to be connected to the microcells in a different manner from each other.

Optionally, each of the plurality of the microcell has a same response coefficient, and accordingly, the photon detector further comprises a plurality of readout interfaces, each readout interface being connected to at least one of the microcells and each readout interface is configured to be connected to the microcells in a different manner from each other.

In a fifth aspect, an electronic device is provided, comprising: a processor and a memory storing computer programs, the processor is configured to realize the method according to the embodiments of the application when executing the computer programs.

In a sixth aspect, a computer readable storage medium is provided, storing computer programs configured to realize the method according to the embodiments of the application when executed.

Nowadays, typically only the entire photosensitive area of a single photon counter device, such as a single SiPM pixel, can be used as the minimum sensing unit for sensing photon signals, and more precise position information cannot be obtained. Such an array of photon counter devices cannot achieve imaging with higher spatial resolution.

In contrast, the method according to the embodiments of the present application may use a photon detector comprising a plurality of microcells to receive incident photons, such that pulse signals are generated by the corresponding microcells which receive the incident photons, read out the generated pulse signals, for different microcells on which a given photon is incident, characteristics of the readout pulse signals being different, and based on the characteristics of the readout pulse signals, determine which corresponding microcells receiving the incident photons and/or determine the incident photon intensity distribution of the microcells of the photon detector. Consequently, different microcells exhibit distinct characteristics in response to the same photon stimulation. By leveraging these characteristic differences, this approach can determine the microcells where incident photons are located or the intensity of photons incident on each microcell. Thus, without altering the physical dimensions of existing photoelectric conversion devices, this approach enables the use of the microcells as the minimum sensing units for detecting photon signals, thereby achieving higher spatial resolution imaging.

The optional features and additional effects of the embodiments are described in part below, while others can be understood by reading the specification.

**Brief Description of Drawings**

The embodiments of the present application will be described in further detail below with reference to the accompanying drawings. The elements shown in the drawings are not necessarily drawn to scale, and similar or identical reference signs in the drawings represent similar or identical elements, wherein:

FIG.1 shows a schematically structural diagram of an exemplary silicon photomultiplier (SiPM),

FIG.2A shows a flow chart of a sub-pixel imaging method according to an embodiment of the present application,

FIG.2B shows a flow chart of a sub-pixel imaging method according to an embodiment of the present application,

FIG.2C shows a flow chart of a sub-pixel imaging method according to an embodiment of the present application,

FIG.2D shows a flow chart of a sub-pixel imaging method according to an embodiment of the present application,

FIG.3A shows a schematically structural diagram of a sub-pixel imaging device according to an embodiment of the present application,

FIG.3B shows a schematically structural diagram of a sub-pixel imaging device according to an embodiment of the present application,

FIG.3C shows a schematically structural diagram of a sub-pixel imaging device according to an embodiment of the present application,

FIG.3D shows a schematically structural diagram of a single microcell according to an embodiment of the present application,

FIG.4 shows a flowchart of a sub-pixel imaging method according to an embodiment of the present application,

FIG.5A shows a module connection diagram of a sub-pixel imaging device according to an embodiment of the present application,

FIG.5B shows a module connection diagram of a sub-pixel imaging device according to an embodiment of the present application,

FIG.5C shows a module diagram of a photon detector of a sub-pixel imaging device according to an embodiment of the present application,

FIG.5D shows a module diagram of a photon detector of a sub-pixel imaging device according to an embodiment of the present application,

FIG.6 shows a flowchart of a sub-pixel imaging method according to an embodiment of the present application,

FIG.7 shows a module connection diagram of a sub-pixel imaging device according to an embodiment of the present application,

FIG.8 shows a module connection diagram of a sub-pixel imaging device according to an embodiment of the present application,

FIG.9A shows a flowchart of a sub-pixel imaging method according to an embodiment of the present application,

FIG.9B shows a flowchart of a sub-pixel imaging method according to an embodiment of the present application,

FIG.10A shows a module connection diagram of a sub-pixel imaging device according to an embodiment of the present application,

FIG.10B shows a module diagram of a photon detector of a sub-pixel imaging device according to an embodiment of the present application, and

FIG.11 shows a schematic diagram of an exemplary hardware structure of an electronic device capable of implementing the method according to an embodiment of the present application.

## Detailed Description

To clarify the purpose, technical solution, and advantages of the present invention, detailed descriptions are provided below in conjunction with specific embodiments and accompanying drawings. It should be noted that the following illustrative embodiments and explanations of the present invention are provided for the purpose of explaining the present invention, and are not intended to limit the scope of the present invention.

In the disclosure, the terms "comprise" and any variations thereof are intended to be inclusive, i.e., indicating "include but not limited to". Unless otherwise specified, the term "or" indicates "and/or". The term "based on" means "at least partially based on". The terms "an exemplary embodiment" and "one embodiment" mean "at least one exemplary embodiment". The term "another embodiment" means "at least one additional embodiment". The terms "first", "second", or the like may refer to different or identical objects. Other explicit and implicit definitions may also be referred to in the followings.

The specific embodiments of the present application will be described in detail below with reference to the accompanying drawings.

The sub-pixel imaging solutions provided in the embodiments of the present application relate to weak light detection technology, more specifically to photon detection, and may be applied in many fields, such as medical imaging technology, high energy physics, laser radar, autonomous driving, precision analysis, optical communication and so on. In a specific example, the sub-pixel imaging method, device, detector, electronic device and storage medium provided in the embodiments of the present application may be applied to positron emission tomography (PET). In the PET system, photon data may be collected according to the solutions described in the embodiments of the present application, and then the image reconstruction may be performed. In other specific examples of the present application, the sub-pixel imaging method, device, detector, electronic device and storage medium provided in the embodiments of the present application may also be applied to one or a combination of the apparatuses that utilize the principle of high-energy ray conversion, such as a CT apparatus, an MRI apparatus, a radiation detection apparatus, an oil detection apparatus, a low light detection apparatus, a SPECT apparatus, a security inspection apparatus, a gamma camera, an X-ray apparatus, and a DR apparatus, and other photoelectric conversion application apparatuses.

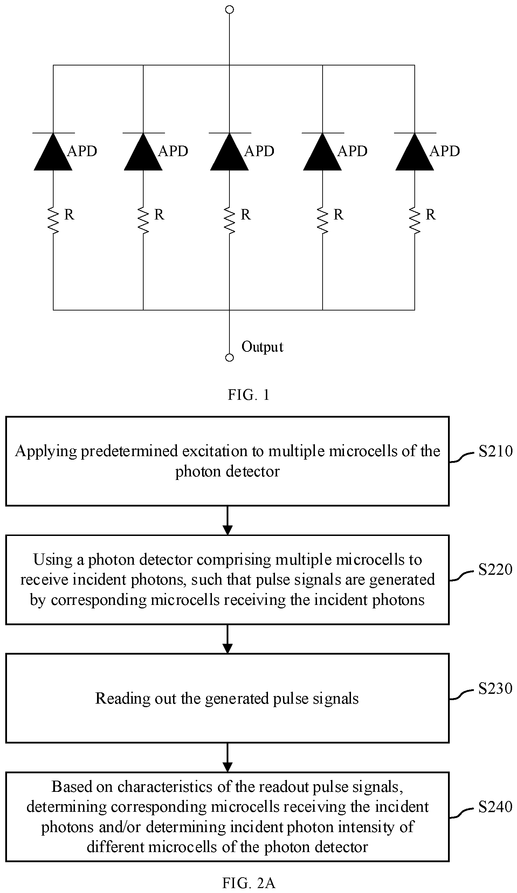

In the embodiments of the present application, a photon detector that may be used for photon signal detection is provided, which is preferably a silicon photomultiplier (SiPM). For example, FIG.1 shows a schematically structural diagram of an exemplary silicon photomultiplier (SiPM). Each SiPM pixel may comprise multiple microcells, and each SiPM is preferably formed as a microcell array including a plurality of microcells. A "microcell" refers to a basic unit that can receive photons and generate pulse signals, and can also be referred to as a "micro-pixel", "sub-pixel", etc. Each microcell may comprise a photon sensing module and a pulse signal generating module. In some embodiments, the photon sensing module may include an avalanche photodiode (APD) or other single photon sensing element. In some embodiments, the pulse signal generating module may include a quenching resistor, a quenching circuit, a transistor, or a circuit capable of converting a transient current into a pulse signal output, such as a circuit composed of a resistor with a relatively greater resistance and a capacitor, where a resistor with a "relatively greater" resistance refers to a resistor that is able to normally operate in the pulse signal generating module or the avalanche photodiode while generating a pulse signal according to the content of the relevant technology in the field, and its resistance value is usually sufficient to quickly share the voltage after the avalanche photodiode generates a voltage signal, such that the voltage across the avalanche photodiode drops below the breakdown voltage. In different embodiments of the present application, the resistance values of the quenching resistors of different microcells may be the same or different, as further described below.

A sub-pixel imaging method and device, an imaging apparatus, an electronic device and a computer readable medium based on the photon detector are also provided in the embodiments of the present application. The photon detector in the embodiments of the present application, through the different microcells or different connection manners or readout manners of the microcells, may achieve that under the same photon stimulation, different pulse signal characteristics may be read out by the readout module or circuit for different microcells, such that where characteristic differences are identifiable, photon detection and imaging at the micrometric level, using microcells as the smallest sensing units, may be achieved through a variety of readout manners and signal reconstruction techniques, without altering the physical dimensions of existing photoelectric conversion devices.

To this end, FIG.2A shows a sub-pixel imaging method according to an embodiment of the present application. The sub-pixel imaging method may comprise the following steps S220, S230, and S240.

S220: using a photon detector comprising a plurality of microcells to receive incident photons, such that pulse signals are generated by the corresponding microcells which receive the incident photons,

S230: reading out the generated pulse signals, and

S240: based on the characteristics of the readout pulse signals, determining which corresponding microcells receiving the incident photons and/or determining the incident photon intensity distribution of different microcells of the photon detector.

In the embodiments of the present application, the photon detector may be a silicon photomultiplier (SiPM), or other devices capable of generating pulse signals, , such as photoelectric conversion devices with the energy amplitude as the characteristic.

In the embodiments of the present application, for different microcells on which a given photon is incident, there are different characteristics of the readout pulse signals. In other words, under the same photon stimulation, different pulse signal characteristics may be read out for different microcells. For example, when the photon detector uses SiPM, an array of microcells with different or not completely identical response coefficients may be arranged in the SiPM. Each microcell generates an electrical pulse signal upon receiving an incident photo. Since the response coefficients corresponding to each microcell are not completely identical or are completely different, the characteristics of the electrical pulse signals output by the microcells are also not completely identical or are completely different.

In the embodiments of the present application, it should be understood that the pulse signal may be any sampleable pulse signal which is a physical quantity that changes abruptly in a short time and then returns to its initial value quickly, and the physical quantity represents some characteristics. The pulse signal may be in a form of an electrical pulse signal, an acoustic pulse signal, a thermal pulse signal, a pressure wave signal or the like. For example, where the pulse signal is an electrical pulse signal, its corresponding characteristics may be the voltage and current of the electrical pulse signal, and where the pulse signal is an acoustic pulse signal, its corresponding characteristics may be the sound intensity of the acoustic pulse signal, and so forth. Further details are not elaborated here.

In the embodiments of the present application, upon applying a predetermined excitation to the microcells, pulse signals may be correspondingly generated by the microcells receiving the incident photons. Specifically, upon applying a bias voltage to the microcells, electrical pulse signals may be correspondingly generated by the microcells receiving the incident photons.

For example, in the embodiment shown in FIG.2A, the sub-pixel imaging method may also comprise:

S210: applying a predetermined excitation to the plurality of microcells of the photon detector.

In the embodiments of the present application, the pulse signals may be identified at the microcell level through the characteristics of the readout pulse signals. In the embodiments of the present application, the incident photons being incident on different microcells may cover at least one of the following situations: a single photon is incident on different microcells, or one or more photons are incident on different microcells.

Specifically, in some embodiments of the present application, the sub-pixel imaging method may be used to achieve microcell-level single photon detection. In these embodiments, where the number of incident photons is low enough, generally only one microcell will receive a photon and output a pulse signal within a normal working period, and the signal is read out from one microcell. In this case, since the characteristic of the pulse signal generated by each microcell correspond to its own property, the corresponding microcell may be directly determined based on the characteristic of the readout pulse signal. For example, the microcells may be configured to have different response coefficients, such that the characteristics of the electrical pulse signals output by the microcells are different. For example, the characteristic of the electrical pulse signal may be represented by the output voltage, such that the microcell on which the photon is incident is incident may be directly determined based on the voltage magnitude of the readout electrical pulse signal.

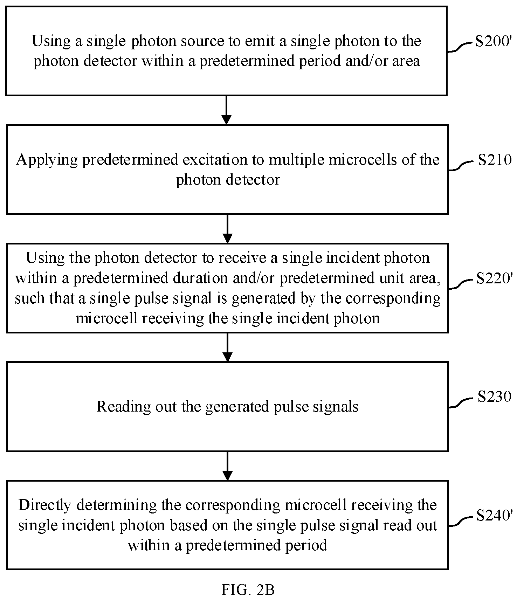

Furthermore, in the exemplary embodiment shown in FIG.2B, a sub-pixel imaging method is shown, which may be used for the single-photon detection, and may comprise the following steps S220', S230, and S240'.

S220': using the photon detector to receive a single incident photon within a predetermined duration and/or a predetermined unit area, such that a single pulse signal is generated by the corresponding microcell receiving the single incident photon,

S230: reading out the generated pulse signal, and

S240': directly determining the corresponding microcell receiving the single incident photon based on the single pulse signal read out within a predetermined period.

Similar to FIG.2A, the embodiment shown in FIG.2B may also correspondingly comprise applying a predetermined excitation, such as applying a bias voltage in the step S210. Under the application of the predetermined excitation, when the number of incident photons is low enough, among all the microcells within a normal working period, only one of the microcells receive the single incident photon.

In some applications of the embodiments of the present application, there may be a variety of manners to generate the single photon. For example, in the embodiment shown in FIG.2B, before receiving the incident photons, the sub-pixel imaging method may further comprise:

S200': using a single photon source to emit the single photon to the photon detector within a predetermined period and/or area.

In the embodiments of the present application, the single photon source may be in various forms, for example, it may be various single photon emitters, such as excited or spontaneously radiating single photon emitters. In the embodiments of the present application, the single photon or one photon refers to photons emitted by a single photon source that are distinguishable from each other by time (predetermined period) and/or area (predetermined area). For example, a single photon source may emit multiple photons at the same time, and these multiple photons may be sparse enough to be received by different microcells, respectively. For example, a single photon source may emit multiple photons in succession within a period of time, and the photon detector has a time resolution sufficient to distinguish the time difference among the multiple photons, so that only one photon is incident within a single working period. Or the photons emitted by the single photon source may be in a from according to the combination of the above two conditions.

In the embodiments of the present application, the sub-pixel imaging method may be used to achieve microcell-level detection of one or more photons. Here, the microcells into which these photons are incident may be determined, or the intensity of incident photons of each microcell may be directly determined.

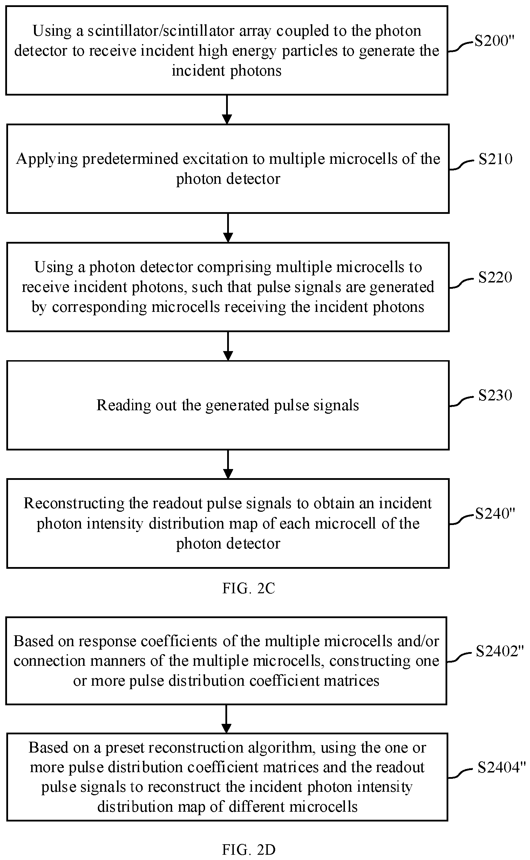

For example, in the exemplary embodiment shown in FIG.2C, a sub-pixel imaging method is shown and may be used for microcell-level detection of one or more photons, comprising steps S220, S230, and S240".

S220: using a photon detector comprising a plurality of microcells to receive incident photons, such that pulse signals are generated by the corresponding microcells which receive the incident photons,

S230: reading out the generated pulse signals,

S240": reconstructing the readout pulse signals to obtain an incident photon intensity distribution map of each microcell of the photon detector.

Similar to FIG.2A, the embodiment shown in FIG.2C may also correspondingly comprise applying a predetermined excitation such as applying a bias voltage in step S210.

In a further specific embodiment, as shown in FIG.2D, step S240" may comprise steps S2402" and S2404".

S2402": based on response coefficients of the plurality of microcells and/or connection manners of the plurality of microcells, constructing one or more pulse distribution coefficient matrices, and

S2404": based on a predetermined reconstruction algorithm, using the one or more pulse distribution coefficient matrices and the readout pulse signals to reconstruct the incident photon intensity distribution map of the microcells.

In some embodiments, the response coefficient of the microcell refers to a parameter that reflects the property of the pulse signal generated thereby. For example, the electrical pulse response coefficient may reflect the intensity of the electrical pulse signal generated by the microcell upon receiving a photon. Since the response coefficient is related to the property of the microcell itself, the microcells with different response coefficients may be obtained by certain detection means, or may be manufactured according to various processes during production. In a specific example, different response coefficients may be achieved by different resistance values of quenching resistors, quenching circuits, transistors or circuits capable of converting the instantaneous current into electrical pulse signals for output, in the microcells or more specifically, in the pulse signal generating module of the microcells.

In some embodiments, a pulse distribution coefficient matrix, for example, a single pulse distribution coefficient matrix corresponding to the response coefficient of each microcell may be constructed based on the response coefficients of the microcells.

In some embodiments, one or more pulse distribution coefficient matrices may be constructed based on different connection manners of the microcells. For example, a set of pulse distribution coefficient matrices are constructed.

In some embodiments, one or more pulse distribution coefficient matrices may be constructed based on both the response coefficients of the microcells and the different connection manners of the microcells. For example, a set of pulse distribution coefficient matrices may be constructed.

In some embodiments, the predetermined reconstruction algorithm may include one or more of the following algorithms: filtered back projection (FBP), maximum likelihood expectation maximization (MLEM), ordered subsets expectation maximization (OSEM), maximum a posteriori estimation (MAP) and the like.

In some embodiments, the reconstruction may be based on iteration and/or fitting.

The pulse distribution coefficient matrix/pulse distribution coefficient matrix set and the predetermined reconstruction algorithm will be further described below in conjunction with the reading out of the pulse signal.

In some applications of the embodiments of the present disclosure, the incident photons may be generated by a scintillator array, for example, when the sub-pixel imaging method or device is applied to an imaging apparatus such as a PET apparatus. Specifically, in some embodiments, as shown in FIG.2C, before receiving the incident photons, the sub-pixel imaging method may further comprise:

S200": using a scintillator array coupled to the photon detector to receive incident high energy particles to generate the incident photons.

Further, in the embodiments of the present application, given that for different microcells on which a given photon is incident, there are different characteristics of the readout pulse signals which are distinguishable from each other, microcell-level sensing of photon signals is achieved, thereby achieving higher spatial resolution of the photon detector.

In the embodiments of the present application, microcell-level sensing imaging can be achieved by different microcells, different microcell connection manners of the microcells, or a combination of both. In other words, the difference in characteristics of the readout pulse signals may be based on different pulse signal characteristics generated by different microcells, based on the same pulse signals generated by different microcells but different readout pulse signals obtained due to different microcell connection manners, based on different pulse signals generated by different microcells and different readout pulse signals obtained through different connection manners, or based on any reasonable combination of the above.

In the embodiment of the present application, a sub-pixel imaging device is accordingly provided. Those skilled in the art will understand that the features of the sub-pixel imaging device provided in the embodiment or other embodiments can be combined with the subpixel imaging methods provided in previous or other embodiments to create new embodiments, and vice versa.

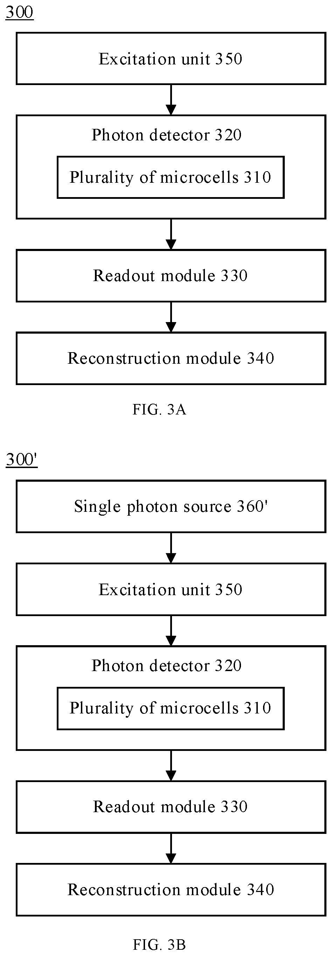

For example, FIG.3A shows a sub-pixel imaging device 300 according to an embodiment of the present application. The sub-pixel imaging device 300 comprises a photon detector 320 comprising a plurality of microcells 310, a readout module 330, and a reconstruction module 340. The photon detector 320 may be configured to receive incident photons, such that pulse signals, such as electrical pulse signals, are generated by the corresponding microcells which receive the incident photons. The readout module 330 may be configured to read out the generated pulse signals, such that for different microcells on which a given photon is incident, there are different characteristics of the readout pulse signals. The "different characteristics of the readout pulse signals" includes: first condition in which different microcells have different properties, such that when a given incident photon is incident on different microcells, each microcell will generate different characteristic of the pulse signal, so the characteristics of the readout pulse signals are different, second condition in which different microcells have the same properties, such that when a incident photon is incident on different microcells, each microcell will generate the same characteristic of the pulse signal, but the connection manners of the readout module 330 to the microcells are different, such that the characteristics of the readout pulse signals corresponding to different microcells are different, third condition in which different microcells have different properties, such that when a given incident photon is incident on different microcells, each microcell will generate different characteristic of the pulse signal, and the connection manner of the readout module 330 to the microcells are different too, such that the characteristics of the readout pulse signals are different. The reconstruction module 340 may be configured to, based on the characteristics of the readout pulse signals, determine which corresponding microcells receiving the incident photons and/or determine the incident photon intensity distribution of the microcells of the photon detector.

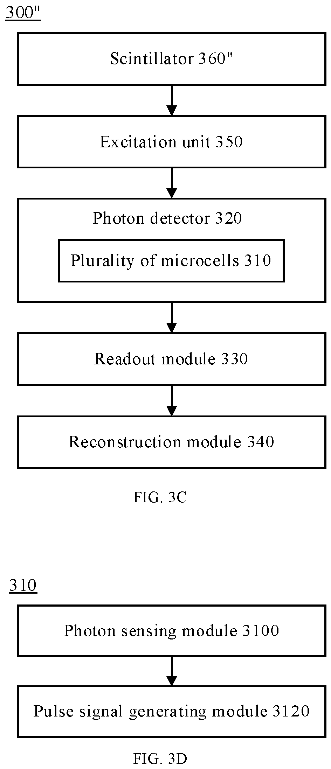

In the embodiment shown in FIG.3A, the photon detector 320 may be a silicon photomultiplier (SiPM). In the preferred embodiment shown in FIG.3A, the photon detector 320, such as a silicon photomultiplier (SiPM), may be in a form of a microcell array including the plurality of microcells 310. As shown in the embodiment of FIG.3D, each microcell 310 may comprise a photon sensing module 3100 and a pulse signal generating module 3120. In some embodiments of the present application, the photon sensing modules 3100 of the microcells may be configured to be the same, for example, the photon sensing modules 3100 of the microcells may be composed of the same material and/or have the same sensing area. In alternative embodiments, the pulse signal generating modules 3120 of the microcells may be configured to be the same or different or not completely the same, for example, specifically, the pulse signal generating modules 3120 of the microcells may be configured to generate the same or different or not completely the same pulse signal characteristics when receiving incident photons, as will be further described below.

In the embodiment shown in FIG.3A, the sub-pixel imaging device 300 may further comprise an excitation unit 350, such as a bias voltage excitation unit, which can be configured to apply a bias voltage to the plurality of microcells 310 of the photon detector 320.

FIG.3B shows a sub-pixel imaging device 300' according to another embodiment of the present application. The sub-pixel imaging device 300' may be similar to the device 300, comprising a photon detector 320 comprising a plurality of microcells 310, a readout module 330 and a reconstruction module 340. And, the sub-pixel imaging device 300' may similarly comprise an excitation unit 350. In addition, the sub-pixel imaging device 300' may further comprise a single photon source 360', which is configured to emit a single photon to the plurality of microcells of the photon detector within a predetermined period and/or in a predetermined area.

FIG.3C shows a sub-pixel imaging device 300" according to an embodiment of the present application. The sub-pixel imaging device 300" may be similar to the device 300, comprising a photon detector 320 comprising a plurality of microcells 310, a readout module 330. And, the sub-pixel imaging device 300" may similarly comprise an excitation unit 350.

Further, the sub-pixel imaging device 300" may comprise a reconstruction module 340, which may be configured to reconstruct the readout pulse signals to obtain the positions of incident photons or an incident photon intensity distribution map of the various microcells of the photon detector.

Further, the sub-pixel imaging device 300" may comprise a scintillator or a scintillator array 360" coupled to the photon detector 320, which may be configured to generate incident photons in response to incident high energy particles.

Optionally, the reconstruction module 340 may comprise a construction sub-module configured to construct one or more pulse distribution coefficient matrices based on the response coefficients of the plurality of microcells and/or the connection manners of the plurality of microcells. Reconstruction module 340 may also comprise a reconstruction sub-module configured to, based on a predetermined reconstruction algorithm, reconstruct an incident photon intensity distribution map of the various microcells according to the one or more pulse distribution coefficient matrices and the readout pulse signals.

In embodiments of the present application, the previous embodiments for single photon detection and multiple photon detection may be combined with the embodiments related to the various readout manners to obtain further embodiments, which falls within the scope of the present invention.

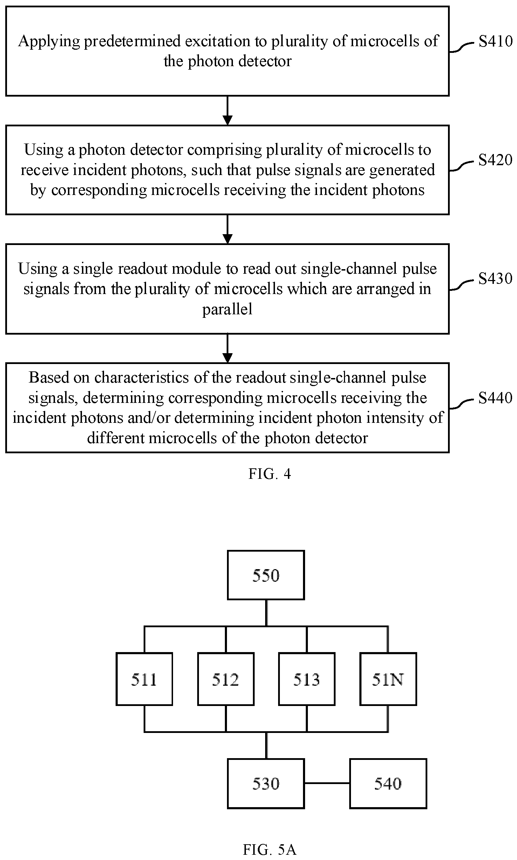

For example, in the embodiment shown in FIG.4, by means of differently configured microcells, different pulse signal characteristics may be read out by various microcells under the same photon stimulation.

In the embodiment shown in FIG.4, at least a portion of the microcells or each of the microcells have different response coefficients from each other.

Specifically, in FIG.4, the sub-pixel imaging method may comprise:

S420: using a photon detector comprising a plurality of microcells to receive incident photons, such that pulse signals are generated by the corresponding microcells which receive the incident photons,

S430: using a single readout module to read out single-channel pulse signals from the plurality of microcells which are arranged in parallel, and

S440: based on characteristics of the readout single-channel pulse signals, determining which corresponding microcells receiving the incident photons and/or determining the incident photon intensity distribution of different microcells of the photon detector.

Optionally, the method may further comprise step S410: applying a predetermined excitation such as a bias voltage to the plurality of microcells of the photon detector.

In some embodiments, a portion of the plurality of microcells may have different response coefficients from each other. In other embodiments, all of the plurality of microcells may have different response coefficients from each other.

Accordingly, FIG.5A also shows a module connection diagram of a corresponding sub-pixel imaging device. Similar to the device 300, the sub-pixel imaging device may comprise a photon detector (not labeled) comprising a plurality of microcells 511, 512, 513, ..., 51N, a readout module 530 and a reconstruction module 540, and the sub-pixel imaging device may similarly comprise an excitation unit 550. Optionally, the reconstruction module 540 may be in a form of an image reconstruction module.

In the sub-pixel imaging device shown in FIG.5A, the plurality of microcells 511, 512, 513, ..., 51N have different response coefficients from each other (indicated by sequentially arranged but different reference signs 511, 512, 513, ..., 51N in this example), and the photon detector has a single readout interface (not labeled) for the readout module 530 to connect to the plurality of parallel arranged microcells 511, 512, 513, ..., 51N.

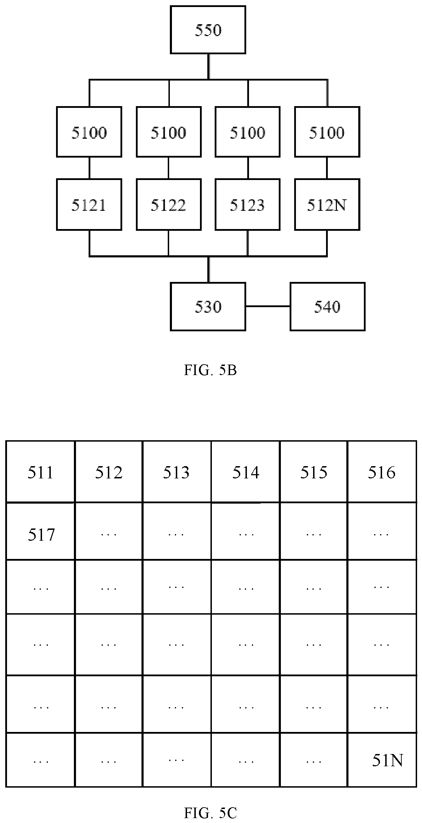

As shown in the embodiment of FIG.5B, it is further shown that each microcell may comprise photon sensing modules 5100 and the pulse signal generating modules 5121, 5122, 5123, ..., 512N, where N is a natural number indicating the number of microcells of the photon detector and may be the same as the number of microcells of the photon detector. In the preferred embodiment shown in FIG.5B, the photon sensing modules 5100 of the microcells may be configured as the same (indicated by the same reference sign 5100 in this example). In some embodiments, the photon sensing modules 5100 of the microcells may be constructed of the same material and/or have the same sensing area. In the preferred embodiment shown in FIG.5B, the pulse signal generating modules 5121, 5122, 5123, ..., 512N are different (indicated by sequentially arranged but different reference signs 5121, 5122, 5123...512N in this example) to make the microcells have different response coefficients from each other, so that in the embodiments shown in FIG.5A or FIG.5B, different pulse signals are generated when a given photon is incident on different microcells. The difference of said generated pulse signals refers to the difference of one or more characteristics of the pulse signals, such as different pulse amplitudes, different pulse shapes, or both different amplitudes and shapes, which falls within the scope of the present invention.

In the embodiments of the present application, the photon sensing module of the microcell is used to receive photons, which may include an avalanche photodiode (APD) or other single photon sensing elements.

In the embodiments of the present application, the pulse signal generating module of the microcell can be configured in different manners, as long as it can generate pulse signals based on the incident photons received by the photon sensing module. For example, it can convert the transient current, generated by the photon sensing module when receiving incident photons, into electrical pulse signals, which may have different electrical pulse signal characteristics (as shown in the embodiments of FIGS.5A and 5B) or the same electrical pulse signal characteristics (as shown in other embodiments of the present application), as needed.

In the embodiments of the present application, the pulse signal generating module may comprise a quenching resistor, a quenching circuit, a transistor, or a similar circuit capable of converting transient current into pulse signal output, such as a circuit composed of a resistor having a relatively great resistance and a capacitor.

In a specific embodiment of the present application, the pulse signal generating module may comprise or be constituted by a quenching circuit composed of resistors and capacitors. Alternatively, in a specific embodiment of the present application, the pulse signal generating module may comprise or be constituted by a quenching circuit composed of resistors. In the embodiment shown in FIG.5B, when it is such a quenching circuit, different resistance values can be set for the pulse signal generating modules of different microcells to achieve different response coefficients.

In a specific embodiment of the present application, the pulse signal generating module may comprise or be constituted of a transistor. In a further specific embodiment, when the pulse signal generating module comprises or is constituted of the transistor, different gains of transistors in pulse signal generating modules of different microcells may be set to achieve different response coefficients.

In the sub-pixel imaging method shown in FIG.4 or the sub-pixel imaging device shown in FIGS.5A and 5B, since the microcells are connected to the readout module in parallel, the pulses generated by all the microcells will be superimposed and acquired as a single channel pulse signal by the readout module 530, such as the readout circuit.

In the embodiment, the readout module 530 may be set as a typical readout circuit for photon detectors, such as a SiPM, for example, which circuit may use an amplifier with I-V (current-voltage) conversion. However, the difference between the photon detector in the embodiments shown in FIGS.4, 5A and 5B and typical photon detectors like SiPM is that different responses to photons incident on different microcells may be provided by different response coefficients of various microcells. These different response coefficients may be provided by different pulse signal generating modules, and for instance, specifically by different resistance values of the pulse signal generating modules.

In the embodiment, the plurality of the microcells may be arranged as a microcell array. For example, in the embodiment shown in FIG.5C, the plurality of the microcells 511, 512, 513, 514, 515, 516, 517, ..., 51N may be arranged as a 6×6 microcell array, but the size (number of rows and columns) of the microcell array is not limited to this. In the embodiment shown in FIG.5C, each microcell 511, 512, 513, 514, 515, 516, 517, ..., 51N has a different response coefficient.

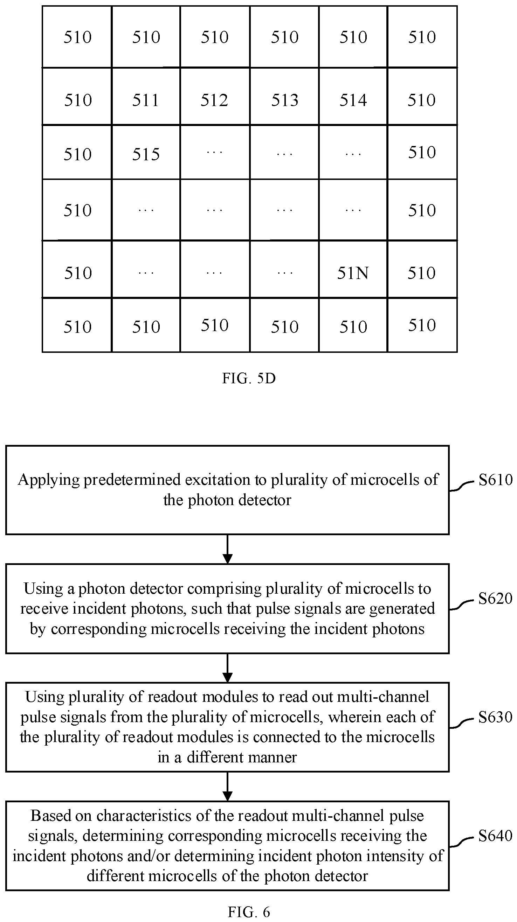

In some embodiments of the present application, a portion of the multiple microcells have different response coefficients. For example, in the microcell array, the pulse generation response coefficients of microcells at certain specific positions may be set to be the same or different. For instance, in the preferred embodiment schematically shown in FIG.5D, in the microcell array, it may be configured such that there are multiple microcells at the edge, such as at least one ring of microcells 510 along the four edges as shown in the embodiment of FIG.5D, having the same response coefficient (here represented by the same reference numeral 510), while other microcells 511, 512, 513, 514, 515, ..., 51N may have different response coefficients from each other (here represented by sequentially arranged but different reference numerals 511, 512, 513, 514, 515...51N). The embodiment of FIG.5D is advantageous in some scenarios because it may effectively avoid edge effects, especially when applied to scintillation crystals, for example, when used for PET with scintillation crystals.

In embodiments with microcell arrays, such as those shown in FIG.5C or FIG.5D, the microcells may be connected in parallel to the readout module, such as the readout circuit, through a single readout interface. Therefore, the pulse signals generated by all microcells will be superimposed and acquired as a single channel pulse signal by the readout module 530, such as the readout circuit. In the embodiment shown in FIG.5C, the incident photon reception of each microcell among the multiple microcells may be determined; in the embodiment shown in FIG.5D, the incident photon reception of each microcell except those in the edge region and the incident photon reception of the microcells in the edge region as a whole may be determined.

As mentioned before, the aforementioned embodiment for single photon detection or multiple photon detection may be combined with various embodiments, such as those shown in FIGS.4, 5A and 5B.

In embodiments combining single photon detection with FIGS.4 and 5A to 5B, when the number of incident photons is sufficiently low, within a specified time period, for example, a time period distinguishable by the readout circuit, one microcell will receive a single photon and generate a pulse signal under the excitation of the excitation unit. The readout module/readout circuit directly reads out this pulse signal and may determine the position of the microcell corresponding to this signal. In this case, the corresponding microcell position may be directly known based on the response coefficient of each microcell.

In embodiments combining multiple photon detection with FIGS.4 and 5A to 5B, image reconstruction may be performed on the readout pulse signals, i.e., the pulse signals obtained by parallel superposition.

Herein, a pulse distribution coefficient matrix K may be constructed based on the different response coefficients of multiple microcells. In the pulse distribution coefficient matrix $K$, the matrix parameters $K_i$ (i=1, 2...N, where N is the number of microcells) may correspond to the response coefficients of the plurality of microcells, such as the microcell array (as shown in FIG.5C or FIG.5D). In some preferred embodiments, the parameters $K_i$ in the pulse distribution coefficient matrix K may be the response coefficients or those parameters processed by normalizing the response coefficients.

Furthermore, based on a preset reconstruction algorithm, the pulse distribution coefficient matrix and the readout pulse signals may be used to reconstruct an incident photon intensity distribution map of the various microcells, thereby obtaining the photon incidence intensity of the various microcells.

Specifically, analytical or iterative methods may be used for reconstruction using the following equation:

$$\sum (K_i * X_i) = Y, \quad i = 1, 2, 3, ..., N$$

where $i$ represents the sequences of the microcells, N is the number of microcells (e.g. $N=6\times6=36$ in the embodiment shown in FIG.5C or FIG.5D), $Ki$ is the response coefficient of the respective microcell, $Xi$ is the number of the photons or the photon intensity received by each microcell in the same time period (predetermined time period), $Y$ is the readout electrical pulse signal, which in this case is the electrical pulse signal read out from the parallel microcells, * represents a preset reconstruction algorithm or its derivative algorithm.

By constructing the pulse distribution coefficient matrix with $Ki$ as parameters accordingly, and using this pulse distribution coefficient matrix and the readout pulse signals, $Xi$ may be solved to reconstruct the incident photon intensity distribution maps of different microcells.

In the embodiments of the present application, as mentioned above, the preset reconstruction algorithm (e.g. the algorithm represented by *) may include one or more of the following algorithms: Filtered Back Projection (FBP), Maximum Likelihood Expectation Maximization (MLEM), Ordered Subset Expectation Maximization (OSEM), Maximum A Posteriori (MAP) estimation, and other methods. The aforementioned derivative algorithms refer to algorithm variants obtained by performing operations such as combination, simplification, transformation, and/or normalization on the basis of the preset reconstruction algorithms without departing from their fundamental principles.

In some embodiments of the present application, the filtered back projection algorithm (FBP) is based on Fourier transform theory. Before back projection, projections under projection angles are convoluted to improve shape artifacts caused by point spread functions and reconstructed image quality is better. Specifically, the projection reconstruction process comprises first taking the projection data obtained on the photon detector for a one-dimensional Fourier transform, then performing convolution operation with the filter function to obtain the convolution filtered projection data under each direction, then back projecting them in each direction, that is, evenly distributing them back onto the corresponding microcell units in their original paths, and superimposing them to obtain the photon intensity value (photon intensity map) of each microcell. Optionally, the filter function may be selected from an R-S filter function or a S-L filter function. In the embodiments of the present application, the filtered back projection algorithm (FBP) may be implemented based on iterations.

In some embodiments of the present application, the maximum likelihood expectation maximization (MLEM) first calculates based on the maximum likelihood theory, and then solves based on the maximum expectation to find estimated solutions with maximum likelihood. In one specific embodiment, it is assumed that the photons detected by the photon detector satisfy independent Poisson distributions, and based on this Poisson distribution model, a likelihood function of the observed data (i.e. the readout electrical pulse signals) is set, and a maximum expectation value is found through an iterative method.

In some embodiments of the present application, the ordered subsets expectation maximization (OSEM) is also an iterative image reconstruction algorithm based on the maximum likelihood expectation method. It divides the electrical pulse signals into L subsets, where L is a natural number, and all pixels (each pixel corresponding to a microcell) are updated once one subset of data is used. One iteration is completed when all subsets have been used in turn. OSEM includes two steps: determining the expression of the conditional expectation of the likelihood function, deriving the pixel update value that maximizes the conditional expectation of the likelihood function by taking the derivative to find the extreme value. The value of the likelihood function obtained after each pixel update is greater than or equal to the previous one, and the pixel value eventually converges to the maximum likelihood.

In some embodiments of the present application, the implementation of maximum a posteriori estimation (MAP) is similar to maximum likelihood, except that a priori distribution of parameters to be estimated (i.e. number of photons received by each microcell/photon intensity) is introduced in maximum likelihood functions. In the embodiments of the present application, maximum a posteriori estimation (MAP) may also be implemented based on iterations.

In some embodiments, the preset reconstruction algorithm may use a combination of the aforementioned multiple algorithms.

Herein, in a specific example similar to FIG.5C, the photon detector, also referred to as a photon counting device, e.g. a silicon photomultiplier (SiPM) may comprise a microcell array consisting of 36 microcells of 6mm×6mm, with each microcell sized 1mm×1mm. Those skilled in the art should understand that there are modifications or combinations as to the specific number, arrangement form, etc. of microcells in the SiPM according to actual application requirements, which are apparently conceivable based on the technical teachings of the present disclosure and will not be elaborated here.

In this specific imaging method comprise: photon incidence, the corresponding microcell photon sensing module receiving photons, where the photon sensing module used by each microcell is the same and uses an avalanche photodiode, which will be triggered under the a reverse bias voltage, generating transient current upon receiving incident photons, setting the response coefficient of each microcell to $K_i$ (i=1,2...36), where each $K_i$ is different and may be calculated from parameters such as resistance values of the pulse signal generating module of the microcell to construct a pulse distribution coefficient matrix, reading the pulse signals from the readout module, and reconstructing the pulse signals read by the readout module to obtain the signal intensity distribution of each microcell.

As previously described, in the embodiments of the present application, microcell-level sensing imaging can be achieved by different microcell connection manners.

For example, FIG.6 shows an embodiment in which microcell-level sensing imaging is achieved through different microcell connection manners and/or combinations of different connection manners and differently configured microcells.

In the embodiment shown in FIG.6, the sub-pixel imaging method comprises:

S620: using a photon detector comprising a plurality of microcells to receive incident photons, such that pulse signals are generated by the corresponding microcells which receive the incident photons,

S630: using a plurality of readout modules to read out multi-channel pulse signals from the plurality of microcells, with each of the plurality of the readout modules connected to the microcells in a different manner from each other, and

S640: based on the characteristics of the readout multi-channel pulse signals, determining which corresponding microcells receiving the incident photons and/or determining the incident photon intensity distribution of different microcells of the photon detector.

Similarly, it may also comprise step S610: applying a predetermined excitation such as a bias voltage to the plurality of microcells of the photon detector.

In some embodiments, each microcell has the same response coefficient.

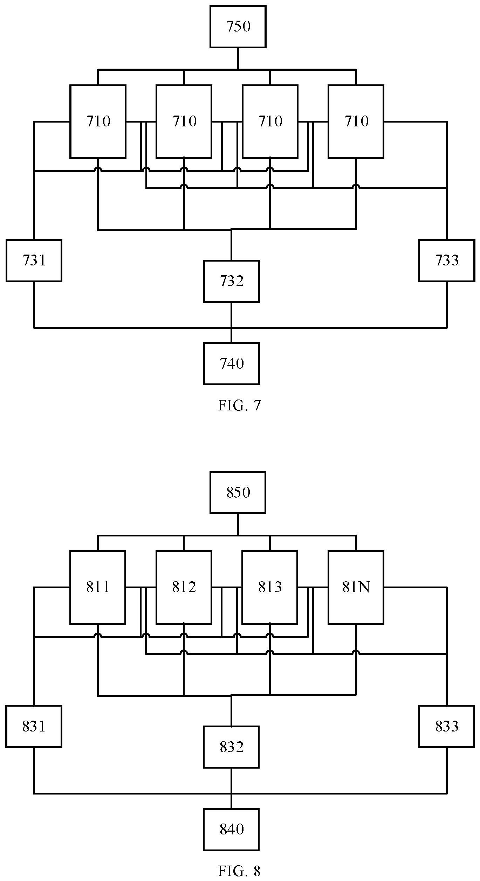

Accordingly, FIG.7 shows a module connection diagram of a sub-pixel imaging device corresponding to the method shown in FIG.6. Similar to the device 300, the sub-pixel imaging device may comprise a photon detector (not labeled) comprising a plurality of microcells 710, a plurality of readout modules 731, 732, 733 and a reconstruction module 740, and similarly, may comprise an excitation unit 750. Optionally, the reconstruction module 740 is an image reconstruction module.

In the sub-pixel imaging device shown in FIG.7, the plurality of microcells 710 have the same response coefficient (indicated by the same reference numeral 710 in this example), and the photon detector comprises a plurality of readout interfaces (not labeled), each readout interface connecting to one readout module 731, 732 or 733.

In the embodiment shown in FIG.7, the photon sensing modules (not shown) of the microcells may be constructed of the same material and/or have the same sensing area. In the preferred embodiment shown in FIG.7, the various pulse signal generating modules may also be configured as the same, such that the microcells have the same response coefficient.

Further, as schematically shown in FIG.7, each readout module 731, 732 or 733 is connected to the microcells 710 in a different manner (indicated by sequentially arranged but different reference numerals 731, 732, and 733 in this example). In the embodiments of the present application, the different connection methods may be in various forms, as long as different microcells may be distinguished based on different readout interfaces/readout modules. That is, when the same photon stimulation acts on different microcells, at least one readout interface/readout module the signals read out have a distinguishable difference. The forms of said different connection manners may include, but are not limited to, connecting microcells of different numbers, connecting microcells in different routing line manners, adding additional components, such as resistors, capacitors, transistors or other circuit elements, to the lines, or any combination of the above. In some embodiments, the number of microcell connection methods, i.e. the number M of readout interfaces/readout modules may be less than or equal to the number of microcells, preferably N=M, as long as microcell-level imaging can be achieved.

As previously described, the aforementioned embodiments for the single photon detection and one or more photon detection may be combined with different embodiments, such as the embodiments shown in FIG.6 and FIG.7.

In the single photon detection combined embodiment, the microcell where the photon comes from can be directly determined based on the connection method of the readout module. Relevant features in other embodiments regarding single photon detection can be incorporated into this document in a non-contradictory manner and are not repeated here.

In the one or more photons detection embodiment, one or more pulse distribution coefficient matrices can be constructed based on different microcell connection manners, for example, to construct a group of pulse distribution coefficient matrices.

An incident photon intensity distribution map of different microcells may be reconstructed based on a preset reconstruction algorithm and using the pulse distribution coefficient matrices (or a matrix group) and the readout electrical pulse signals, thereby obtaining the photon incidence intensity of different microcells.

Specifically, analytical or iterative methods may be used for reconstruction using the following equation:

$$\sum\sum \left( K_{i,j} * X_i \right) = Y_j$$

where $i$ represents the sequences of the microcells $i = 1,2,3, ..., N$, $N$ is the number of microcells, $j$ is the readout module/readout interface number, $j = 1,2,3, ... , M$, $M$ is the number of readout modules/readout interfaces, $K_{i,j}$ is the response coefficient of each microcell corresponding to each readout interface/readout module, $X_i$ is the number of photons/photon intensity received by each microcell in the same time period (predetermined time period), $Y_j$ is the electrical pulse signal read out from each readout interface/from the readout module, * represents the preset reconstruction algorithm or its derivative algorithm.

The difference between the embodiments shown in FIGS.6 and 7 and those shown in FIG.4 and FIGS.5A to 5D is that the embodiments shown in FIGS.6 and 7 use a group of pulse distribution coefficient matrices, while the embodiments shown in FIG.4 and FIGS.5A to 5D use a single pulse distribution coefficient Matrix. In addition, in the embodiments shown in FIGS.6 and 7, the response coefficients of the microcells represented by the aforementioned $K_i$ take into account the different connection methods of microcells corresponding to different readout interfaces/readout modules. Specifically, the response coefficients of the microcells in the matrix may be obtained by numerical operations based on the determined connection relationship. For example, when a readout interface/readout module is not connected to one or more microcells, the K value corresponding to the unconnected microcell may be marked as a zero value or a specific constant.

Those skilled in the art will understand that features of various embodiments may be combined with the embodiments shown in FIGS.6 and 7, which will not be elaborated herein. For example, the preset algorithm described in the embodiments shown in FIGS.6 and 8 may employ algorithms described in other embodiments.

Herein, in embodiments corresponding to FIG.7, the pulse signal generating modules of the plurality of microcells are the same but have multiple outputs (i.e., multiple readout interfaces/readout modules).

In some embodiments, each microcell has a different response coefficient. As shown in the embodiment of FIG.8, while having multiple outputs (i.e., multiple readout interfaces/readout modules), the pulse signal generating modules of the plurality of microcells are configured to be different.

Accordingly, FIG.8 shows a module connection diagram of a sub-pixel imaging device corresponding to FIG.6. Similar to device 300, the sub-pixel imaging device may comprise a photon detector (not labeled) comprising a plurality of microcells 811, 812, 813, ...81N, a plurality of readout modules 831, 832 and 833 and a reconstruction module 840, and similarly, may comprise a voltage unit 850.

In the sub-pixel imaging device shown in FIG.8, the plurality of microcells 810 have different response coefficients from each other (indicated by sequentially arranged but different reference numerals 811, 812, 813, ...81N in this example), and the photon detector has multiple readout interfaces (not labeled), each readout interface connecting to a readout module 831, 832 or 833.

In the embodiment shown in FIG.8, the photon sensing modules (not shown) of the microcells may be composed of the same material and/or have the same sensing area. In the preferred embodiment shown in FIG.8, the various pulse signal generating modules may be different to make the microcells have different response coefficients from each other.

Further, as schematically shown in FIG.8, each readout module 831, 832 or 833 is connected to the microcells 810 in a different manner (indicated by sequentially arranged but different reference numerals 831, 832, 833 in this example).

As previously described, the previous embodiments for single photon detection and one or more photon detection may be combined with various embodiments, such as the embodiments shown in FIG.6 and FIG.8.

In the embodiments for single photon detection, the microcell where the photon comes from may be directly determined based on the connection manners of the readout modules. Relevant features in other embodiments regarding single photon detection may be incorporated herein in a non-contradictory manner and will not be elaborated.

In the embodiments for one or more photons detection, one or more pulse distribution coefficient matrices may be constructed based on different microcell connection manners, for example, to construct a group of pulse distribution coefficient matrices.

An incident photon intensity distribution map of different microcells may be reconstructed based on a preset reconstruction algorithm and using the pulse distribution coefficient matrices (or a matrix group) and the readout pulse signals, thereby obtaining the photon incidence intensity of different microcells.

Specifically, analytical or iterative methods may be used for reconstruction using the following equation:

$$\sum\sum\left(K_{i,j} * X_i\right) = Y_j$$

Where $i$ represents the sequences of the microcells $i = 1,2,3, ..., N$, $N$ is the number of microcells, $j$ is the readout module/readout interface number, $j = 1,2,3, ..., M$, $M$ is the number of readout modules/readout interfaces, $K_{i,j}$ is the response coefficient of each microcell corresponding to each readout interface/readout module, $X_i$ is the number of photons/photon intensity received by each microcell in the same time period (predetermined time period), $Y_j$ is the electrical pulse signal read out from each readout interface/from the readout module, $*$ represents the preset reconstruction algorithm or its derivative algorithm.

The difference between the embodiments shown in FIGS.6 and 8 and those shown in FIG.4 and FIGS.5A to 5D is that the embodiments shown in FIGS.6 and 8 use a group of pulse distribution coefficient matrices, while the embodiments shown in FIG.4 and FIGS. 5A to 5D use a single pulse distribution coefficient matrix. In addition, in the embodiments shown in FIGS.6 and 8, the response coefficients of the microcells represented by the aforementioned $K_i$ take into account the different connection manners of microcells corresponding to different readout interfaces/readout modules. Specifically, the pulse response coefficients of the microcells in the matrix may be obtained by numerical operations based on the determined connection relationship. For example, when a readout interface/readout module is not connected to one or more microcells, the $K$ value corresponding to the unconnected microcell may be marked as a zero value or a specific constant.

Those skilled in the art will understand that features of other embodiments may be combined with the embodiments shown in FIGS.6 and 8, which will not be elaborated. For example, the preset algorithm described in the embodiments shown in FIGS.6 and 8 may employ algorithms described in other embodiments.

In the embodiment of the application, microcell-level sensing imaging may be achieved partly through differently configured microcells, and partly through different microcell connection manners.

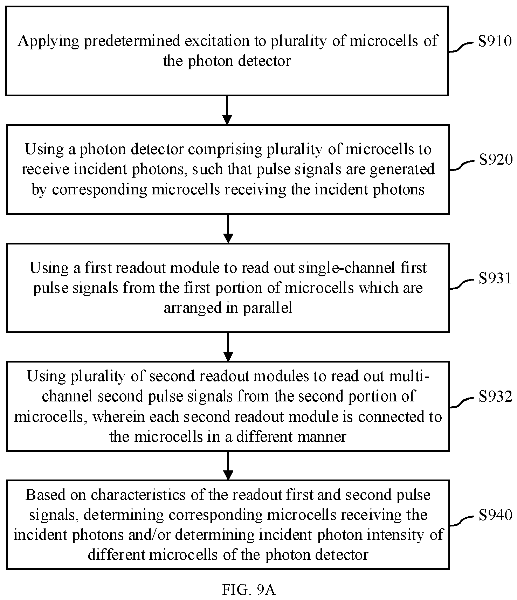

As shown in the embodiment of FIG.9A, the sub-pixel imaging method comprises:

S920: using a photon detector comprising a plurality of microcells to receive incident photons, such that pulse signals are generated by the corresponding microcells which receive the incident photons,

S931: using a first readout module to read out single-channel first pulse signals from a first portion of the microcells which are arranged in parallel,

S932: using a plurality of second readout modules to read out multi-channel second pulse signals from a second portion of the microcells, wherein each of the second readout modules is connected to the microcells in a different manner,

S940: based on the characteristics of the readout first and second pulse signals, determining which corresponding microcells receiving the incident photons and/or determining the incident photon intensity distribution of different microcells of the photon detector.

In this case, a first portion of the plurality of microcells have different response coefficients from each other, a second portion of the plurality of microcells have the same response coefficient,

Similarly, it may also comprise step S910: applying a bias voltage to the microcell array of the photon detector.

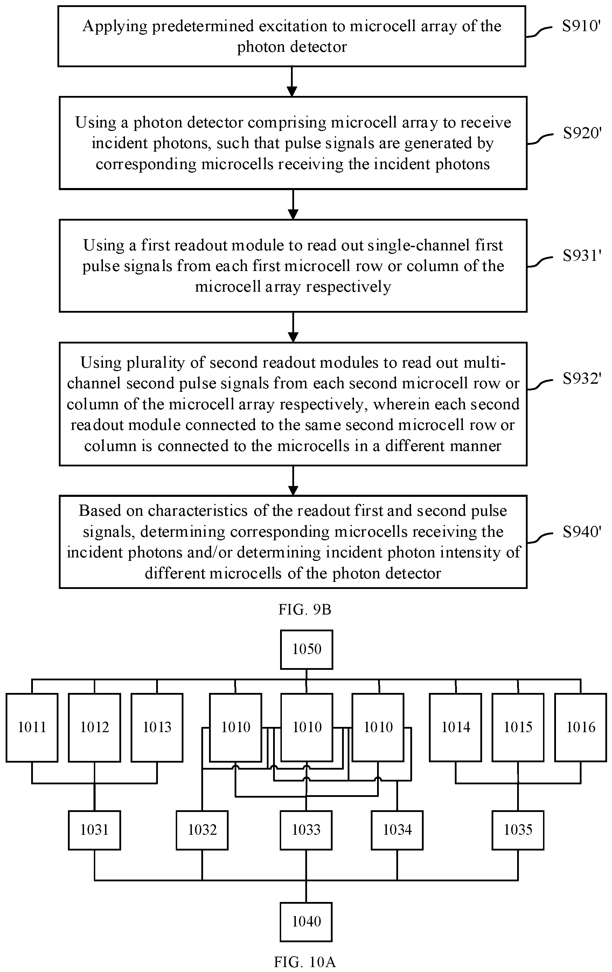

Accordingly, in the embodiment shown in FIG.10A, a module connection diagram of the sub-pixel imaging device corresponding to the method shown in FIG.9A is also provided. Similar to device 300, this sub-pixel imaging device may comprise a photon detector (not labeled) with multiple microcells 1010, 1011, 1012, 1013, 1014, 1015, 1016, a plurality of readout modules 1031, 1032, 1033, 1034, 1035, and a reconstruction module 1040. Additionally, it can similarly comprise a voltage unit 1050.

In the embodiment shown in FIG.10A, in the sub-pixel imaging device, a portion of the microcells 1011, 1012, 1013; 1014, 1015, 1016, i.e., the first portion of microcells, have different response coefficients (indicated here by different reference numerals). A portion of the microcells 1010, i.e., the second portion of microcells, have the same response coefficient (indicated here by the same reference numeral 1010).

In the embodiment shown in FIG.10A, the photon detector comprises multiple readout interfaces (not labeled), with each readout interface connected to one readout module.

In the embodiment shown in FIG.10A, the microcells with different response coefficients are connected in parallel to the readout interface/module. In the specific embodiment shown in FIG.10A, the first portion of microcells is divided into two groups, wherein the first group 1011, 1012, 1013 is connected in parallel to 1031 to produce a single-channel readout pulse signal, and the second group 1014, 1015, 1016 is connected in parallel to 1035 to produce a single-channel readout pulse signal.

In the embodiment shown in FIG. 10A, the second portion of microcells with the same response coefficient is connected to readout interfaces/modules 1032, 1033, 1034 through different connection methods. In the shown embodiment, the number of microcells in the second portion equals the number of readout interfaces/-modules. Although only one group of the second portion of microcells is shown in the figure, it may be conceivable that the second portion of microcells may also be grouped.

The embodiments corresponding to Figures 9A and 10A may also be applied to single-photon and/or multi-photon detection as described above.

In the embodiments for the single-photon detection, the microcell where the photon comes from may be directly determined based on different response coefficients or different connection manners of readout modules 1031, 1035 or 1032, 1033, 1034. Relevant features of single-photon detection in other embodiments may be incorporated herein in a non-contradictory manner and will not be elaborated.

In the embodiments for one or more photon detection, one or more pulse distribution coefficient matrices, for example, a group of pulse distribution coefficient matrices may be constructed based on the different connection manners of microcells.

The embodiments corresponding to Figures 9A and 10A may be combined with the aforementioned reconstruction methods.

Based on a preset reconstruction algorithm, the pulse distribution coefficient matrices (or group of matrices) and the readout electrical pulse signals may be used to reconstruct an incident photon intensity distribution map of different microcells, thereby obtaining the photon incidence intensity of different microcells.

Specifically, analytical or iterative methods may be used for reconstruction using the following equation:

$$\sum\sum\left(K_{i,j} * X_i\right) = Y_j$$

Where $i$ represents the sequences of the microcells $i = 1,2,3, ..., N$, $N$ is the number of microcells, $j$ is the readout module/readout interface number, $j = 1,2,3, ..., M$, $M$ is the number of readout modules/readout interfaces, $K_{i,j}$ is the response coefficient of each microcell corresponding to each readout interface/readout module, $X_i$ is the number of photons/photon intensity received by each microcell in the same time period (predetermined time period), $Y_j$ is the electrical pulse signal read out from each readout interface/from the readout module, * represents the preset reconstruction algorithm or its derivative algorithm.

In the embodiments shown in FIG. 9A and 10A, the response coefficient of each microcell represented by $K_{i,j}$ takes into account the different connection manner of microcells corresponding to readout interfaces/modules. Specifically, the response coefficients of microcells in the matrices may be obtained through numerical operations determined based on connection relationships. For example, when a readout interface/module is not connected to one or more microcells, the $K$ value corresponding to the unconnected microcells may be marked as zero or a specific constant.

In the shown embodiment, smaller pulse distribution coefficient matrices or sparser pulse distribution coefficient matrices than those in Figures 6 to 8 may be set, which has the advantage of faster computation speed for image reconstruction using iteration or fitting.

Those skilled in the art will understand that features of other embodiments can be incorporated into the embodiments shown in FIGS. 9A and 10A to avoid repetitive descriptions. For example, the preset algorithm mentioned in the embodiments shown in FIGS. 9A and 10A may use algorithms mentioned in other embodiments.

In the preferred embodiment of this application, the plurality of the microcells may be constructed into a microcell array, and microcell-level sensing imaging may be achieved partly through different microcells and partly through different connection manners of microcells based on rows or columns of the microcell array.

As shown in the embodiment of Figure 9B, the sub-pixel imaging method includes:

s920': using a photon detector comprising a microcell array to receive incident photons, such that pulse signals are generated by corresponding microcells which receive the incident photons;

s931': using a first readout module to read out a first, single-channel pulse signals from each first microcell row or column of the microcell array respectively;

s932': using a plurality of second readout modules to read out second, multi-channel pulse signals from each second microcell row or column of the microcell array respectively, wherein each second readout module connected to the same second microcell row or column connects to the microcells in a different manner in the respective second microcell row or column; and

s940': based on the characteristics of the readout first and second pulse signals, determining which corresponding microcell receiving the incident photon and/or determining the incident photon intensity of different microcells of the photon detector,

wherein each first microcell row or column has different response coefficients from each other, and each second microcell row or column has the same response coefficient.

Similarly, it may also comprise step S910: applying a bias voltage to the microcell array of the photon detector.

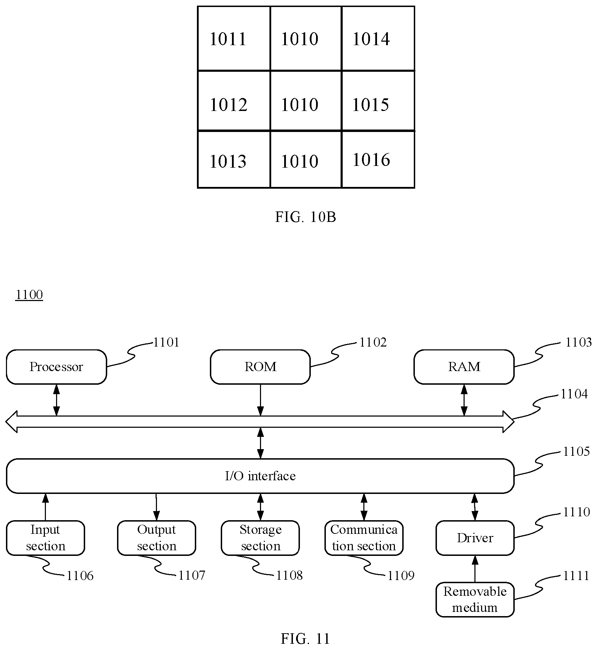

Accordingly, a sub-pixel imaging device corresponding to the method shown in FIG.9B may also be provided. FIG.10B shows a module diagram of the microcell array of the photon detector of the sub-pixel imaging device. The microcell array shown in FIG. 10B may configure the microcells and/or connect the readout modules in a manner similar to FIG.10A.

As shown in FIG.10B, the *i-th* column (*i=1, 3*) of the microcell array, i.e. the first microcell column with microcells 1011, 1012, 1013, 1014, 1015, 1016, may be divided into two groups, each group having different response coefficients from each other, which can be parallel connected to one respective, single readout interfaces/readout modules as shown in FIG.10A.

As shown in FIG.10B, the *i-th* column (*i=2*) of the microcell array, i.e. the second microcell column with microcells 1010 having the same response coefficient, and may, in different connection manners as shown in FIG.10A, connect to the plurality of readout interfaces/-readout modules.

Although for simplicity of illustration, FIG.10B schematically shows only one column of microcells adopting different connection manners to connect to the plurality of readout interfaces/readout modules, it can be contemplated that multiple columns of microcells can each connect to multiple readout interfaces/readout modules corresponding to the respective columns. In addition, although an arrangement based on columns is shown in FIG.10B, an arrangement based on rows can also be contemplated.

The inventor has found that such a row-column arrangement has a particularly advantageous in being able to achieve microcell-level sensing imaging faster with fewer computing resources.

For brevity, similar features in FIGS.9A and 10A can be referenced to implement similar features in FIGS.9B and 10B, which will not be elaborated here.

Thus, in the embodiments of the present application, microcell-level imaging can be achieved by different microcells or different microcell connection manners (multi-channel signal readout methods or different signal reconstruction methods) or a combination thereof in photoelectric devices.

In some embodiments, an imaging apparatus comprising the sub-pixel imaging device according to any embodiment of the present application is also provided. Preferably, the imaging apparatus is selected from any of a PET apparatus, a CT apparatus, an MRI apparatus, a radiation detection apparatus, an oil detection apparatus, a low light detection apparatus, an SPET apparatus, a security inspection apparatus, a gamma camera, an X-ray apparatus, a DR apparatus and other devices utilizing high energy ray conversion principles, and other photoelectric conversion application apparatus or any combination of the above apparatuses.

Those skilled in the art will understand that the devices and apparatuses described in the embodiments of the present application may combine the features of the methods described in the embodiments of the present application, and vice versa.

The embodiments of the present application also relate to electronic devices capable of implementing the methods according to the embodiments of the present application.

In some embodiments, an electronic device is provided, which may comprise a processor and a memory storing computer programs, wherein the processor is configured to execute a method according to any embodiment of the present application when executing the computer programs.

FIG.11 shows an exemplary hardware structure diagram of an electronic device 1100 that can implement the methods according to embodiments of the present application. In some embodiments, more or fewer electronic devices than shown may be included. In some embodiments, implementation may utilize a single or multiple electronic devices. In some embodiments, cloud or distributed electronic devices may be utilized for implementation.

As shown in FIG.11, the electronic device 1100 includes a processor 1101 that performs various appropriate operations and processing according to programs and/or data stored in read only memory (ROM) 1102 or loaded from storage section 1108 into random access memory (RAM) 1103 or programs and/or data. The processor 1101 may be a single-core or multi-core processor, and may also include multiple processors. In some embodiments, the processor 1101 may include a general-purpose main processor (such as a CPU) and one or more special co-processors, such as a graphics processor (GPU), a neural network processor (NPU), a digital signal processor (DSP), or other general-purpose or special-purpose integrated circuits. Various programs and data required for the operation of the electronic device 1100 are also stored in the RAM 1103. The processor 1101, ROM 1102, and RAM 1103 are connected to each other via bus 1104. An input/output (I/O) interface 1105 is also connected to the bus 1104.

The components below are connected to the I/O interface 1105: an input section 1106 including a keyboard, mouse, etc., an output section 1107 including components such as a display and speakers, a storage section 1108 including a hard disk, etc., and a communication section 1109 including a network interface card such as a LAN card and modem. The communication section 1109 performs communication processing via a network such as the Internet. Driver 1110 is also connected to I/O interface 1105 as needed. Removable medium 1111 such as magnetic disks, optical disks, magneto-optical disks, semiconductor memory, etc. can be installed on driver 1110 as needed such that computer programs read from it can be installed into storage section 1108 as necessary.

FIG.11 merely shows an exemplary electronic device schematically, but the electronic device according to the embodiments of the present application may include more or fewer components than the device shown in FIG.11 or have the same, partially the same or different architectures as the embodiment shown in FIG.11.

In some embodiments, said electronic device can also be combined with various components to obtain other signal detection systems with the advantages of the present invention.

Although not shown, in some embodiments a computer readable storage medium storing computer programs is also provided, wherein the computer programs are configured to execute any method according to an embodiment of the application when run. The computer program contains program modules/units constituting the respective devices according to embodiments of the application. When executed, the computer program constituted by the program modules/units can achieve functions corresponding to the respective steps in the methods described in the embodiments. The computer program can also run on electronic devices as described in the embodiments of the application.

The storage media in the embodiments of the application include non-volatile and/or volatile articles that can store information by any method or technology. Non-volatile memory may include read only memory (ROM), programmable ROM (PROM), electrically programmable ROM (EPROM), electrically erasable programmable ROM (EEPROM), or flash memory. Volatile memory may include random access memory (RAM) or external cache memory. By way of illustration rather than limitation, RAM is available in many forms such as static RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), Rambus direct RAM (RDRAM), direct Rambus dynamic RAM (DRDRAM), and Rambus dynamic RAM (RDRAM), etc.

Those skilled in the art will understand that the embodiments described in this specification can be implemented in multiple forms such as methods, systems or computer program products. Therefore, those skilled in the relevant art can understand that the functional modules/units described in the embodiments or the realization of the related method steps by the controller can be implemented by software, hardware, or a combination of software and hardware.

Unless explicitly stated, according to the methods, actions or steps of the methods described in the embodiments of the application do not necessarily have to be performed in a particular order and parallel processing is also possible or may be advantageous in certain embodiments.

Multiple embodiments have been described with reference to the accompanying drawings, but for brevity, the descriptions of the various embodiments are not exhaustive and the same or similar features or parts of the different embodiments may be omitted. In this document, "one embodiment", "some embodiments", "example", "specific example", or "some examples" refer to at least one embodiment or example according to the application rather than all embodiments. The above terms do not necessarily refer to the same embodiments or examples. Unless mutually contradictory, those skilled in the art can combine the different embodiments or examples described in this specification as well as features of different embodiments or examples.

The exemplary systems and methods provided in accordance with the embodiments have been described in detail above with reference to the accompanying drawings, which are only the best methods for implementing the systems and methods. Those skilled in the art can understand that various changes can be made to the implementations of the systems and methods described herein without departing from the spirit and scope of the invention as defined in the appended claims, such as arranging multiple photon sensing modules or multiple pulse signal generating modules in the same microcell, or using different combinations of different element quantities, connections, etc. according to the teachings of the present invention.

**Claims**

1.　A sub-pixel imaging method, **characterized by** comprising:

　　　using a photon detector comprising a plurality of microcells to receive incident photons, such that pulse signals are generated by the corresponding microcells which receive the incident photons,
　　　reading out the generated pulse signals, wherein for different microcells on which a given photon is incident, there are different characteristics of the readout pulse signals, and

based on the characteristics of the readout pulse signals, determining which corresponding microcells receiving the incident photons and/or determining the incident photon intensity distribution of the microcells of the photon detector.

2. The sub-pixel imaging method according to claim 1, **characterized in that** the microcells comprise a photon sensing module and a pulse signal generating module, wherein the photon sensing module receives the incident photons, and the pulse signal generating module generates the pulse signals.

3. The sub-pixel imaging method according to claim 2, **characterized in that** the photon detector comprises a silicon photomultiplier, the photon sensing module comprises an avalanche photodiode, and the pulse signal generating module is selected from any of a quenching resistor, a quenching circuit and a transistor.

4. The sub-pixel imaging method according to claim 1, 2 or 3, **characterized in that** at least a portion of the microcells or each of the microcells have different response coefficients from each other.

5. The sub-pixel imaging method according to claim 4, **characterized in that** reading out the generated pulse signals comprises:
using a single readout module to read out single-channel pulse signals from the plurality of the microcells which are arranged in parallel.

6. The sub-pixel imaging method according to claim 4, **characterized in that** reading out the generated pulse signals comprises:
using a plurality of readout modules to read out multi-channel pulse signals from the plurality of microcells, with each of the plurality of the readout modules connected to the microcells in a different manner from each other.

7. The sub-pixel imaging method according to claim 4, **characterized in that** at least a portion of or each of the microcells are configured with a different pulse signal generating module from each other, such that at least a portion of or each of the microcells have different response coefficients from each other.

8. The sub-pixel imaging method according to claim 1, 2 or 3, **characterized in that** each of the plurality of the microcells has a same response coefficient, and wherein reading out the generated pulse signals, comprises:
using a plurality of readout modules to read out multi-channel pulse signals from the plurality of the microcells, wherein each of the plurality of the readout modules is connected to the microcells in a different manner from each other.

9. The sub-pixel imaging method according to claim 4, **characterized in that** the plurality of the microcells have a first portion of the microcells with different response coefficients from each other, and a second portion of the microcells having the same response coefficient, and wherein reading out the generated pulse signals, comprises:

using a first readout module to read out single-channel pulse signals from the first portion of the microcells which are arranged in parallel, and using a plurality of second readout modules to read out multi-channel pulse signals from the second portion of the microcells, wherein each of the second readout modules is connected to the microcells in a different manner from each other.

10. The sub-pixel imaging method according to claim 1, 2 or 3, **characterized in that** the plurality of the microcells have a first portion of the microcells with different response coefficients from each other, and a second portion of the microcells having the same response coefficient, and wherein reading out the generated pulse signals, comprises:

using a plurality of first readout modules to read out multi-channel pulse signals from the first portion of the microcells, wherein each of the first readout modules is connected to the microcells in a different manner from each other, and using a plurality of second readout modules to read out multi-channel pulse signals from the second portion of the microcells, wherein each of the second readout modules is connected to the microcells in a different manner from each other.

11. The sub-pixel imaging method according to claim 1, 2 or 3, **characterized in that** the plurality of the microcells form a microcell array comprising one or more first microcell rows or columns and one or more second microcell rows or columns, each first microcell row or column has different response coefficients from each other, each second microcell row or column has the same response coefficient, and wherein reading out the generated pulse signals, comprises:

using a first readout module to read out single-channel pulse signals from each first microcell row or column, respectively, and using a plurality of second readout modules to read out multi-channel pulse signals from the respective second microcell rows or columns, respectively, wherein each of the second readout module connected to the same second microcell row or column is connected to the microcells in a different manner from each other.

12. The sub-pixel imaging method according to claim 1, 2 or 3, **characterized in that** the plurality of the microcells form a microcell array comprising one or more first microcell rows or columns and one or more second microcell rows or columns, each first microcell row or column has different response coefficients from each other, each second microcell row or column has the same response coefficient, and wherein reading out the generated pulse signals, comprises:

   using a plurality of first readout modules to read out multi-channel pulse signals from the respective first microcell rows or columns, respectively, wherein each of the first readout modules connected to the same first microcell row or column is connected to the microcells in a different manner from each other, and
   using a plurality of second readout modules to read out multi-channel pulse signals from the respective second microcell rows or columns, respectively, wherein each of the second readout module connected to the same second microcell row or column is connected to the microcells in a different manner from each other.

13. The sub-pixel imaging method according to claim 1, 2 or 3, **characterized in that** at least a portion of or each of the microcells is configured to have a photon sensing module and a pulse signal generating module of the same such that at least the portion or each of the microcells have the same response coefficient.

14. The sub-pixel imaging method according to claim 1, 2 or 3, **characterized in that** based on the characteristics of the readout pulse signals, determining the incident photon intensity distribution of the microcells of the photon detector, comprises:
   reconstructing the readout pulse signals to obtain an incident photon intensity distribution map of each microcell of the photon detector.

15. The sub-pixel imaging method according to claim 14, **characterized in that** reconstructing the readout pulse signals to obtain an incident photon intensity distribution map of each microcell of the photon detector, comprises:

   based on response coefficients of the plurality of microcells and/or connection manners of the plurality of microcells, constructing one or more pulse distribution coefficient matrices, and based on a predetermined reconstruction algorithm, using the one or more pulse distribution coefficient matrices and the readout pulse signals to reconstruct the incident photon intensity distribution map of the microcells.

16. The sub-pixel imaging method according to claim 1, 2 or 3, **characterized in that** based on the characteristics of the readout pulse signals, determining which corresponding microcells receiving the incident photons, comprises:
   reconstructing the read pulse signals to obtain the positions of the microcells receiving the photons in the photon detector.

17. The sub-pixel imaging method according to claim 16, **characterized in that** reconstructing the read pulse signals to obtain the positions of the microcells receiving the photons in the photon detector, comprises:
   establishing a correspondence between characteristics of the pulse signals and the microcells with different response coefficients, and determining the positions of the corresponding microcells based on the correspondence and the different characteristics of the readout pulse signals.

18. The sub-pixel imaging method according to claim 1, 2 or 3, **characterized in that** wherein using a photon detector comprising a plurality of microcells to receive incident photons, comprises: using the photon detector to receive a single incident photon within a predetermined duration and/or a predetermined unit area, such that a single pulse signal is generated by the corresponding microcell receiving the single incident photon, and
   wherein based on the characteristics of the readout pulse signals, determining which corresponding microcells receiving the incident photons, comprises: directly determining the corresponding microcell receiving the single incident photon based on the single pulse signal read out within a predetermined period.

19. The sub-pixel imaging method according to claim 1, 2 or 3, **characterized by** further comprising:
   applying a predetermined excitation to the plurality of the microcells of the photon detector.

20. The sub-pixel imaging method according to claim 19, wherein the predetermined excitation comprises a bias voltage.

21. The sub-pixel imaging method according to claim 1, 2 or 3, **characterized by** before receiving the incident photons, further comprising:

using a scintillator or a scintillator array coupled to the photon detector to receive incident high energy particles to generate the incident photons.

22. A sub-pixel imaging device, **characterized by** comprising:

a photon detector comprising a plurality of microcells configured to receive incident photons, such that pulse signals are generated by the corresponding microcells which receive the incident photons,
a readout module configured to read out the generated pulse signals, wherein for different microcells on which a given photon is incident, there are different characteristics of the readout pulse signals, and
a reconstruction module configured to based on the characteristics of the readout pulse signals, determine which corresponding microcells receiving the incident photons and/or determine the incident photon intensity distribution of the microcells of the photon detector.

23. The sub-pixel imaging device according to claim 22, **characterized in that** the microcells comprise a photon sensing module and a pulse signal generating module, wherein the photon sensing module receives the incident photons, and the pulse signal generating module generates the pulse signals.

24. The sub-pixel imaging device according to claim 23, **characterized in that** the photon detector comprises a silicon photomultiplier, the photon sensing module comprises an avalanche photodiode, and the pulse signal generating module is selected from any of a quenching resistor, a quenching circuit and a transistor.

25. The sub-pixel imaging device according to claim 22, 23 or 34, **characterized in that** at least a portion of the microcells or each of the microcells have different response coefficients from each other.

26. The sub-pixel imaging device according to claim 25, **characterized in that** the sub-pixel imaging device comprises a single readout module configured to read out single-channel pulse signals from the plurality of the microcells which are arranged in parallel.

27. The sub-pixel imaging device according to claim 25, **characterized in that** the sub-pixel imaging device comprises a plurality of readout modules with each readout module connected to the microcells in a different manner from each other, wherein the plurality of the readout modules are configured to read out multi-channel pulse signals from the plurality of microcells.

28. The sub-pixel imaging device according to claim 25, **characterized in that** at least a portion of or each of the microcells are configured with a different pulse signal generating module from each other, such that at least a portion of or each of the microcells have different response coefficients from each other.

29. The sub-pixel imaging device according to claim 22, 23 or 24, **characterized in that** each of the plurality of the microcells has a same response coefficient, and the sub-pixel imaging device comprises a plurality of readout modules with each readout module connected to the microcells in a different manner from each other, and wherein the plurality of the readout modules are configured to read out multi-channel pulse signals from the plurality of microcells.

30. The sub-pixel imaging device according to claim 22, 23 or 24, **characterized in that** the plurality of the microcells have a first portion of the microcells with different response coefficients from each other, and a second portion of the microcells having the same response coefficient,
wherein the readout module comprises a first readout module and a plurality of second readout modules, wherein the first readout module is configured to read out single-channel pulse signals from the first portion of the microcells which are arranged in parallel, and the plurality of the second readout modules are configured to read out multi-channel pulse signals from the second portion of the microcells, wherein each of the second readout modules is connected to the microcells in a different manner from each other.

31. The sub-pixel imaging device according to claim 22, 23 or 24, **characterized in that** the plurality of the microcells have a first portion of the microcells with different response coefficients from each other, and a second portion of the microcells having the same response coefficient, and
the readout module comprises a plurality of first readout modules and a plurality of second readout modules, wherein the plurality of the first readout modules are configured to read out multi-channel pulse signals from the first portion of the microcells, wherein each of the first readout modules is connected to the microcells in a different manner from each other, and the plurality of the second readout modules read out multi-channel pulse signals from the second portion of the microcells, wherein each of the second readout modules is connected to the microcells in a different manner from each other.

32. The sub-pixel imaging device according to claim 22, 23 or 24, **characterized in that** the plurality of the microcells form a microcell array comprising one or more first microcell rows or columns and one or more second microcell rows or columns, each first microcell row or column has different response coefficients from each other, each second microcell row or column has the same response coefficient, and wherein the readout module comprises a first readout module and a plurality of second readout modules, wherein the first readout module is configured to read out single-channel pulse signals from each first microcell row or column, respectively, and the plurality of the second readout modules are configured to read out multi-channel pulse signals from the respective second microcell rows or columns, respectively, wherein each of the second readout module connected to the same second microcell row or column is connected to the microcells in a different manner from each other.

33. The sub-pixel imaging device according to claim 22, 23 or 24, **characterized in that** the plurality of the microcells form a microcell array comprising one or more first microcell rows or columns and one or more second microcell rows or columns, each first microcell row or column has different response coefficients from each other, each second microcell row or column has the same response coefficient, and wherein the readout module comprises a plurality of first readout modules and a plurality of second readout modules, wherein the plurality of the first readout modules are configured to read out multi-channel pulse signals from the respective first microcell rows or columns, respectively, wherein each of the first readout modules connected to the same first microcell row or column is connected to the microcells in a different manner from each other, and the plurality of the second readout modules are configured to read out multi-channel pulse signals from the respective second microcell rows or columns, respectively, wherein each of the second readout module connected to the same second microcell row or column is connected to the microcells in a different manner from each other.

34. The sub-pixel imaging device according to claim 22, 23 or 24, **characterized in that** at least a portion of or each of the microcells is configured to have the photon sensing module and the pulse signal generating module of the same such that at least the portion or each of the microcells have the same response coefficient.

35. The sub-pixel imaging device according to claim 22, 23 or 24, **characterized in that** the reconstruction module is configured to use one or more pulse distribution coefficient matrices constructed based on the response coefficients of the plurality of microcells and/or the connection manners of the plurality of microcells, and a predetermined reconstruction algorithm to reconstruct an incident photon intensity distribution map of the microcells.

36. The sub-pixel imaging device according to claim 22, 23 or 24, **characterized in that** the reconstruction module is configured to determine the positions of the corresponding microcells based on a pre-established correspondence between characteristics of the pulse signals and the microcells with different response coefficients, and the different characteristics of the readout pulse signals.

37. The sub-pixel imaging device according to claim 22, 23 or 24, **characterized in that** the photon detector is configured to receive a single incident photon within a predetermined duration and/or a predetermined unit area, such that a single pulse signal is generated by the corresponding microcell receiving the single incident photon, wherein the readout module is configured to read out the single pulse signal generated within a predetermined period, and wherein the reconstruction module is configured to directly determine the corresponding microcell receiving the single incident photon based on the single pulse signal read out within the predetermined period.

38. The sub-pixel imaging device according to claim 22, 23 or 24, **characterized by** further comprising:
an excitation unit configured to apply a predetermined excitation to the plurality of the microcells of the photon detector.

39. The sub-pixel imaging device according to claim 38, **characterized in that** the predetermined excitation comprises a bias voltage.

40. The sub-pixel imaging device according to claim 22, 23 or 24, **characterized by** further comprising:
a scintillator or a scintillator array coupled to the photon detector, wherein the scintillator or the scintillator array is configured to generate the incident photons in response to incident high energy particles.

41. An imaging apparatus, **characterized by** comprising the sub-pixel imaging device according to any of claims 22 to 40.

42. The imaging apparatus according to claim 41, **characterized in that** the imaging apparatus is selected from one of or any combination of a PET apparatus, a CT apparatus, an MRI apparatus, a radiation detection apparatus, an oil detection apparatus, a low light detection apparatus, a SPECT apparatus, a security inspection apparatus, a gamma camera, an X-ray apparatus and a DR apparatus.

43. A photon detector, comprising a plurality of microcells, **characterized in that** the microcells comprise a photon sensing module and a pulse signal generating module, the photon sensing module is configured to receive an incident photon, the pulse signal generating module is configured to generate a pulse signal based on the received incident photon, wherein for different microcells on which a given photon is incident, there are different characteristics of the readout pulse signals.

44. The photon detector according to claim 43, **characterized in that** at least a portion of the plurality of the microcells have different response coefficients from each other.

45. The photon detector according to claim 43, **characterized in that** each of the plurality of the microcells has different response coefficient from each other.

46. The photon detector according to claim 43, **characterized in that** the photon detector comprises a silicon photomultiplier, the photon sensing module comprises an avalanche photodiode, and the pulse signal generating module is selected from any of a quenching resistor, a quenching circuit and a transistor.

47. The photon detector according to any of claims 43 to 46, **characterized by** further comprising a single readout interface, wherein the plurality of the microcells are arranged to be in parallel connected to the single readout interface.

48. The photon detector according to any of claims 43 to 46, **characterized by** further comprising a plurality of readout interfaces, each readout interface is connected to at least one of the microcells, and each readout interface is configured to be connected to the microcells in a different manner from each other.

49. The photon detector according to claim 43, **characterized in that** each of the plurality of the microcell has a same response coefficient, the photon detector further comprises a plurality of readout interfaces, each readout interface is connected to at least one of the microcells and each readout interface is configured to be connected to the microcells in a different manner from each other.

50. An electronic device, **characterized by** comprising: a processor and a memory storing computer programs, the processor is configured to realize the method according to any of claims 1 to 21.

51. A computer readable storage medium, **characterized by** storing computer programs, the computer programs are configured to realize the method according to any of claims 1 to 21.

FIG. 1

Applying predetermined excitation to multiple microcells of the photon detector — S210

Using a photon detector comprising multiple microcells to receive incident photons, such that pulse signals are generated by corresponding microcells receiving the incident photons — S220

Reading out the generated pulse signals — S230

Based on characteristics of the readout pulse signals, determining corresponding microcells receiving the incident photons and/or determining incident photon intensity of different microcells of the photon detector — S240

FIG. 2A

Using a single photon source to emit a single photon to the photon detector within a predetermined period and/or area — S200'

Applying predetermined excitation to multiple microcells of the photon detector — S210

Using the photon detector to receive a single incident photon within a predetermined duration and/or predetermined unit area, such that a single pulse signal is generated by the corresponding microcell receiving the single incident photon — S220'

Reading out the generated pulse signals — S230

Directly determining the corresponding microcell receiving the single incident photon based on the single pulse signal read out within a predetermined period — S240'

FIG. 2B

Using a scintillator/scintillator array coupled to the photon detector to receive incident high energy particles to generate the incident photons ⟋S200"

Applying predetermined excitation to multiple microcells of the photon detector ⟋S210

Using a photon detector comprising multiple microcells to receive incident photons, such that pulse signals are generated by corresponding microcells receiving the incident photons ⟋S220

Reading out the generated pulse signals ⟋S230

Reconstructing the readout pulse signals to obtain an incident photon intensity distribution map of each microcell of the photon detector ⟋S240"

FIG. 2C

Based on response coefficients of the multiple microcells and/or connection manners of the multiple microcells, constructing one or more pulse distribution coefficient matrices ⟋S2402"

Based on a preset reconstruction algorithm, using the one or more pulse distribution coefficient matrices and the readout pulse signals to reconstruct the incident photon intensity distribution map of different microcells ⟋S2404"

FIG. 2D

300

Excitation unit 350

Photon detector 320

Plurality of microcells 310

Readout module 330

Reconstruction module 340

FIG. 3A

300'

Single photon source 360'

Excitation unit 350

Photon detector 320

Plurality of microcells 310

Readout module 330

Reconstruction module 340

FIG. 3B

300"

| Scintillator 360" |
|---|

↓

| Excitation unit 350 |
|---|

↓

| Photon detector 320 |
|---|
| Plurality of microcells 310 |

↓

| Readout module 330 |
|---|

↓

| Reconstruction module 340 |
|---|

FIG. 3C

310

| Photon sensing module 3100 |
|---|

↓

| Pulse signal generating module 3120 |
|---|

FIG. 3D

Applying predetermined excitation to plurality of microcells of the photon detector — S410

Using a photon detector comprising plurality of microcells to receive incident photons, such that pulse signals are generated by corresponding microcells receiving the incident photons — S420

Using a single readout module to read out single-channel pulse signals from the plurality of microcells which are arranged in parallel — S430

Based on characteristics of the readout single-channel pulse signals, determining corresponding microcells receiving the incident photons and/or determining incident photon intensity of different microcells of the photon detector — S440

FIG. 4

550

511    512    513    51N

530    540

FIG. 5A

FIG. 5B

FIG. 5C

| 510 | 510 | 510 | 510 | 510 | 510 |
|-----|-----|-----|-----|-----|-----|
| 510 | 511 | 512 | 513 | 514 | 510 |
| 510 | 515 | · · · | · · · | · · · | 510 |
| 510 | · · · | · · · | · · · | · · · | 510 |
| 510 | · · · | · · · | · · · | 51N | 510 |
| 510 | 510 | 510 | 510 | 510 | 510 |

FIG. 5D

Applying predetermined excitation to plurality of microcells of the photon detector — S610

↓

Using a photon detector comprising plurality of microcells to receive incident photons, such that pulse signals are generated by corresponding microcells receiving the incident photons — S620

↓

Using plurality of readout modules to read out multi-channel pulse signals from the plurality of microcells, wherein each of the plurality of readout modules is connected to the microcells in a different manner — S630

↓

Based on characteristics of the readout multi-channel pulse signals, determining corresponding microcells receiving the incident photons and/or determining incident photon intensity of different microcells of the photon detector — S640

FIG. 6

FIG. 7

FIG. 8

EP 4 509 881 A1

Applying predetermined excitation to plurality of microcells of the photon detector ⟋ S910

Using a photon detector comprising plurality of microcells to receive incident photons, such that pulse signals are generated by corresponding microcells receiving the incident photons ⟋ S920

Using a first readout module to read out single-channel first pulse signals from the first portion of microcells which are arranged in parallel ⟋ S931

Using plurality of second readout modules to read out multi-channel second pulse signals from the second portion of microcells, wherein each second readout module is connected to the microcells in a different manner ⟋ S932

Based on characteristics of the readout first and second pulse signals, determining corresponding microcells receiving the incident photons and/or determining incident photon intensity of different microcells of the photon detector ⟋ S940

FIG. 9A

| Applying predetermined excitation to microcell array of the photon detector | S910' |

↓

| Using a photon detector comprising microcell array to receive incident photons, such that pulse signals are generated by corresponding microcells receiving the incident photons | S920' |

↓

| Using a first readout module to read out single-channel first pulse signals from each first microcell row or column of the microcell array respectively | S931' |

↓

| Using plurality of second readout modules to read out multi-channel second pulse signals from each second microcell row or column of the microcell array respectively, wherein each second readout module connected to the same second microcell row or column is connected to the microcells in a different manner | S932' |

↓

| Based on characteristics of the readout first and second pulse signals, determining corresponding microcells receiving the incident photons and/or determining incident photon intensity of different microcells of the photon detector | S940' |

FIG. 9B

```
                          ┌──────┐
                          │ 1050 │
                          └──────┘

┌──────┐┌──────┐┌──────┐┌──────┐┌──────┐┌──────┐┌──────┐┌──────┐┌──────┐
│ 1011 ││ 1012 ││ 1013 ││ 1010 ││ 1010 ││ 1010 ││ 1014 ││ 1015 ││ 1016 │
└──────┘└──────┘└──────┘└──────┘└──────┘└──────┘└──────┘└──────┘└──────┘

     ┌──────┐     ┌──────┐  ┌──────┐ ┌──────┐       ┌──────┐
     │ 1031 │     │ 1032 │  │ 1033 │ │ 1034 │       │ 1035 │
     └──────┘     └──────┘  └──────┘ └──────┘       └──────┘

                          ┌──────┐
                          │ 1040 │
                          └──────┘
```

FIG. 10A

| 1011 | 1010 | 1014 |
|------|------|------|
| 1012 | 1010 | 1015 |
| 1013 | 1010 | 1016 |

FIG. 10B

1100

| Processor ~1101 | ROM ~1102 | RAM ~1103 |

~1104

I/O interface ~1105

| Input section | Output section | Storage section | Communication section | Driver ~1110 |

~1106 ~1107 ~1108 ~1109

Removable medium ~1111

FIG. 11

<div align="center">**INTERNATIONAL SEARCH REPORT**</div>

| International application No. |
| --- |
| **PCT/CN2022/136856** |

**A. CLASSIFICATION OF SUBJECT MATTER**

G01T1/24(2006.01)i;H01L27/146(2006.01)i;H01L31/0224(2006.01)i

According to International Patent Classification (IPC) or to both national classification and IPC

**B. FIELDS SEARCHED**

Minimum documentation searched (classification system followed by classification symbols)

IPC: G01T H01L

Documentation searched other than minimum documentation to the extent that such documents are included in the fields searched

Electronic data base consulted during the international search (name of data base and, where practicable, search terms used)

CNTXT; CNKI; WPABSC; ENTXTC; ENTXT; DWPI; WEB OF SCIENCE: 像素, 亚像素, 微元, 光子, 响应系数, 位置, 确定, 不同, 区别, 读出, 方式, 脉冲, photodetector, array, photon, pixel, position, photodiodes

**C. DOCUMENTS CONSIDERED TO BE RELEVANT**

| Category* | Citation of document, with indication, where appropriate, of the relevant passages | Relevant to claim No. |
| --- | --- | --- |
| PX | CN 114966806 A (RAYCAN TECHNOLOGY CO., LTD. (SUZHOU)) 30 August 2022 (2022-08-30) <br> claims 1-51 | 1-51 |
| X | US 2012068050 A1 (MAZZILLO, M. C. et al.) 22 March 2012 (2012-03-22) <br> claim 18, and description, paragraphs [0026]-[0050] | 1-5, 7, 13-26, 28, 34-47, 50, 51 |
| A | US 2018348381 A1 (SONY CORP.) 06 December 2018 (2018-12-06) <br> entire document | 1-51 |
| A | US 2021368119 A1 (PANASONIC INTELLECTUAL PROPERTY MANAGEMENT CO., LTD.) 25 November 2021 (2021-11-25) <br> entire document | 1-51 |

☐ Further documents are listed in the continuation of Box C.  ☑ See patent family annex.

| | |
| --- | --- |
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **21 February 2023** | **28 February 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
**Information on patent family members**

International application No.

**PCT/CN2022/136856**

| Patent document cited in search report | | | Publication date (day/month/year) | Patent family member(s) | | | Publication date (day/month/year) |
|---|---|---|---|---|---|---|---|
| CN | 114966806 | A | 30 August 2022 | None | | | |
| US | 2012068050 | A1 | 22 March 2012 | US | 9121766 | B2 | 01 September 2015 |
| US | 2018348381 | A1 | 06 December 2018 | US | 11280918 | B2 | 22 March 2022 |
| US | 2021368119 | A1 | 25 November 2021 | US | 11290675 | B2 | 29 March 2022 |

Form PCT/ISA/210 (patent family annex) (July 2022)

**REFERENCES CITED IN THE DESCRIPTION**

**Patent documents cited in the description**

- CN 202210372869